Europäisches Patentamt

European Patent Office

Office européen des brevets

(19)

(11) Veröffentlichungsnummer: **0 025 086**
**B1**

(12) **EUROPÄISCHE PATENTSCHRIFT**

(45) Veröffentlichungstag der Patentschrift:
15.06.83

(21) Anmeldenummer: 80103255.8

(22) Anmeldetag: **12.06.80**

(51) Int. Cl.³: **G 01 S 7/28**, G 01 S 13/10,
G 01 R 29/02

(54) **Verfahren und Anordnung zur Impulsabstandsmessung bei periodischen Impulspaaren.**

(30) Priorität: **13.06.79 DE 2923963**

(43) Veröffentlichungstag der Anmeldung:
**18.03.81 Patentblatt 81/11**

(45) Bekanntmachung des Hinweises auf die Patenterteilung:
**15.06.83 Patentblatt 83/24**

(84) Benannte Vertragsstaaten:
**CH FR GB IT LI NL SE**

(56) Entgegenhaltungen:
**DE-A-2 508 974**
**DE-A-2 544 842**
**DE-A-2 723 355**

(73) Patentinhaber: **Endress u. Hauser GmbH u.Co.,
Hauptstrasse 1, D-7867 Maulburg (DE)**

(72) Erfinder: **Sartorius, Wilfried, Ing. grad.,
Ernst-Hänssler-Strasse 20, D-7853 Steinen (DE)**

(74) Vertreter: **Leiser, Gottfried, Dipl.-Ing. et al,
Patentanwälte Prinz, Bunke & Partner Ernsberger
Strasse 19, D-8000 München 60 (DE)**

## Verfahren und Anordnung zur Impulsabstandsmessung bei periodischen Impulspaaren

Die Erfindung betrifft ein Verfahren und eine Anordnung zur Impulsabstandsmessung bei periodischen Impulspaaren, insbesondere bei der Impuls-Rückstrahlortung, durch Messung des Zeitabstands zwischen den Zeitpunkten der Koinzidenz einer Impulsflanke mit einem Triggerpegel, der in einem vorgegebenen Verhältnis zum Spitzenwert der Impulse eingestellt wird.

Bei der Messung des Zeitabstandes zwischen den beiden Impulsen aufeinanderfolgender Impulspaare kann es zu Meßfehlern kommen, wenn die Amplituden der Impulse Schwankungen unterworfen sind. Dies ist insbesondere bei der Entfernungsmessung nach dem Impuls-Rückstrahlprinzip der Fall, bei welchem der Zeitabstand zwischen jedem der periodisch ausgesendeten Sendeimpulse und dem aufgrund eines am Ziel reflektierten Echos erhaltenen Empfangsimpuls als Maß für die Entfernung des Ziels gemessen wird. Die Amplitude der Empfangsimpulse kann nämlich infolge veränderlicher Reflexions- und Ausbreitungsbedingungen großen und schnellen Schwankungen unterworfen sein. Die Meßfehler entstehen dann dadurch, daß die Impulse eine endliche Anstiegszeit und die für die Impulsabstandsmessung verwendeten Schaltungen eine von Null verschiedene Ansprechschwelle haben. Wenn zur Zeitmessung die Koinzidenz der ansteigenden Impulsflanken mit einem fest eingestellten Triggerpegel verwendet wird, verschieben sich die Koinzidenzzeitpunkte in Abhängigkeit von der Impulsamplitude, weil die Anstiegszeit der Impulsflanken, die insbesondere durch die Bandbreite der verwendeten Schaltungen bedingt ist, unabhängig von der Impulsamplitude konstant ist.

Es ist bekannt, die durch schwankende Impulsamplituden verursachten Meßfehler dadurch zu verringern, daß der Triggerpegel nicht konstant gehalten, sondern in Abhängigkeit von der Impulsamplitude nachgeregelt wird. Da jedoch die Amplitude eines Impulses erst nach dem Ende der Anstiegsflanke bekannt ist, in deren Verlauf die Koinzidenz festgestellt werden muß, kann der Triggerpegel für jeden Impuls nur aufgrund der Amplitude eines oder mehrerer vorhergehender Impulse eingestellt werden. Es können also auch bei Anwendung dieser Maßnahme noch Meßfehler vorkommen, wenn sich die Impulsamplitude zwischen zwei aufeinanderfolgenden Impulsen stark ändert; die Messung kann sogar ausfallen, wenn die Amplitude eines Impulses kleiner als der aufgrund der Amplitude des vorhergehenden Impulses eingestellte Triggerpegel ist.

Auf bestimmten Anwendungsgebieten, beispielsweise bei der Messung kurzer Entfernungen nach dem Radarprinzip mit Infrarotimpulsen, liegen die zu messenden Zeitabstände zwischen den Impulsen und die erforderlichen Meßgenauigkeiten im Nano- und Subnano-Sekundenbereich. Da für die Messung so kurzer Zeiten sehr schnelle Schaltungen großer Bandbreite benötigt werden, ist es bekannt, bei periodischen Vorgängen die Messung nicht an den Echtzeit-Signalen vorzunehmen, sondern an mit Hilfe des »Sampling-Verfahrens« zeittransformierten Signalen. Das bekannte Sampling-Verfahren besteht darin, daß aus jeder der aufeinanderfolgenden Impulsperioden ein Abtastwert entnommen wird, wobei die zeitliche Lage der Abtastwerte in bezug auf den Beginn jeder Impulsperiode von Periode zu Periode geringfügig verschoben ist. Diese Abtastung wird durch Abtastimpulse gesteuert, deren Periode um eine festgelegte, sehr kleine Zeitdifferenz größer ist als die abzutastenden Impulsperioden. Jeder Abtastwert wird bis zur nächsten Abtastung gespeichert. Die aneinandergefügten Abtastwerte ergeben somit eine Abbildung der abgetasteten Impulsperioden, jedoch in einem um einen Zeittransformationsfaktor gedehnten Zeitmaßstab. Es handelt sich also um eine Art elektronischer stroboskopischer Abtastung.

Die Impulsabstandsmessung kann an den durch das Sampling-Verfahren erhaltenen zeittransformierten Impulsen in der gleichen Weise vorgenommen werden wie an den Echtzeitimpulsen, d. h. durch Feststellung der Koinzidenz der ansteigenden Impulsflanken mit einem Triggerpegel, der gegebenenfalls aufgrund der Amplitude eines vorhergehenden zeittransformierten Impulses eingestellt werden kann. Natürlich sind auch die gemessenen Zeitabstände um den Zeittransformationsfaktor gedehnt.

Hinsichtlich der zuvor geschilderten Auswirkungen der Schwankungen der Impulsamplituden auf die Meßgenauigkeit ergibt das Sampling-Verfahren jedoch keinen Vorteil. Da die Zeitabstände zwischen den für die Messung verwendeten zeittransformierten Impulsen um ein Vielfaches größer sind als die Zeitabstände zwischen den Echtzeitimpulsen, ist die Wahrscheinlichkeit sehr viel größer, daß sich die Impulsamplitude zwischen zwei aufeinanderfolgenden Meßzyklen stark ändert.

Aufgabe der Erfindung ist die Schaffung eines Verfahrens, mit welchem die Zeitabstände zwischen den Impulsen periodischer Impulspaare unter Ausnutzung der Vorteile des Sampling-Verfahrens gemessen werden können, ohne daß die Meßgenauigkeit durch Schwankungen der Impulsamplituden beeinträchtigt wird und einer zugehörigen Anordnung.

Ausgehend von einem Verfahren der eingangs angegebenen Art wird diese Aufgabe nach der Erfindung dadurch gelöst, daß die Impulspaare nach dem Sampling-Verfahren mit Hilfe von Abtastimpulsen abgetastet werden, deren Folgeperiode um eine vorgegebene kleine Zeitdifferenz kleiner als die Folgeperiode der Impulspaare ist, daß für jeden durch die Abtastung erhaltenen zeittransformierten Impuls der Spitzenwert festgestellt und der im vorgegebenen Verhältnis zum Spitzenwert stehende Triggerpegel eingestellt wird, und daß die Messung des Zeitabstands zwischen den Zeitpunkten der Koinzidenz an Hand der Koinzidenz der hinteren Impulsflanke jedes zeittransformierten Impulses mit dem zugehörigen Triggerpegel erfolgt.

Bei dem erfindungsgemäßen Verfahren wird eine Abänderung des üblichen Sampling-Verfahrens angewendet, das eine zeitinvertierte Abtastung ergibt. Dies bedeutet, daß die durch die Abtastung erhaltene zeittransformierte Impulsperiode zwar ein genaues Abbild der Echtzeitperioden ist, aber die umgekehrte zeitliche Lage hat. Jeder zeittransformierte Impuls hat somit den umgekehrten zeitlichen Verlauf wie die Echtzeitimpulse, so daß seine Vorderflanke den Rückflanken der Echtzeitimpulse und seine Rückflanke den Vorderflanken der Echtzeitimpulse entspricht. Ferner ist auch die gegenseitige zeitliche Lage der zeittransformierten Impulse innerhalb der Impulsperiode umgekehrt; bei einem Rückstrahl-Ortungssystem erscheint also der zeittransformierte Empfangsimpuls vor dem zeittransformierten Sendeimpuls. Da aber bei dem erfindungsgemäßen Verfahren der Zeitabstand zwischen den Rückflanken der zeittransformierten Impulse gemessen wird, die den Vorderflanken der Echtzeitimpulse entsprechen, wird die richtige zeittransformierte Meßzeit erhalten.

Der wesentliche Vorteil der Zeitinvertierung im zeittransformierten Bereich liegt darin, daß die Amplitude jedes zeittransformierten Impulses vor der für die Messung verwendeten Rückflanke vorhanden ist. Der für die Messung angewendete Triggerpegel kann daher aufgrund der Amplitude des gleichen Impulses eingestellt werden. Unterschiedliche Impulsamplituden aufeinanderfolgender zeittransformierter Impulse wirken sich daher nicht auf die Meßgenauigkeit aus.

Mit der Erfindung werden ferner Anordnungen zur Durchführung des erfindungsgemäßen Verfahrens geschaffen, die sich insbesondere durch einen einfachen Aufbau auszeichnen.

Die Merkmale besonderer Ausführungsarten der Erfindung ergeben sich aus den abhängigen Ansprüchen. Nachfolgend sind Ausführungsbeispiele anhand der Zeichnung beschrieben. In der Zeichnung zeigt

Fig. 1 ein Diagramm zur Erläuterung der Impulsabstandsmessung bei einem Rückstrahl-Ortungssystem,

Fig. 2 ein Diagramm zur Erläuterung der Auswirkungen von Impulsamplituden-Schwankungen auf die Meßgenauigkeit,

Fig. 3 ein Diagramm zur Erläuterung einer bekannten Maßnahme zur Beseitigung der in Fig. 2 dargestellten Erscheinung,

Fig. 4 ein Diagramm zur Erläuterung der Auswirkungen schneller Amplitudenschwankungen bei der üblichen Anwendung der in Fig. 3 dargestellten Maßnahme,

Fig. 5 Diagramme zur Erläuterung des üblichen Sampling-Verfahrens,

Fig. 6 Diagramme zur Erläuterung der Anwendung des üblichen Sampling-Verfahrens auf die Impulsabstandsmessung,

Fig. 7 Diagramme zur Erläuterung des bei der Erfindung angewendeten zeitinvertierten Sampling-Verfahrens,

Fig. 8 Diagramme ähnlich Fig. 7 zur Erläuterung einer anderen Art der Erzeugung der Abtastimpulse für das zeitinvertierte Sampling-Verfahren,

Fig. 9 Diagramme zur Erläuterung der Anwendung des zeitinvertierten Sampling-Verfahrens auf die Impulsabstandsmessung,

Fig. 10 das Blockschaltbild einer Anordnung zur Durchführung des anhand von Fig. 9 erläuterten Verfahrens,

Fig. 11 Diagramme zur Erläuterung der Funktionsweise der Anordnung von Fig. 10,

Fig. 12 eine Abänderung eines Teils der Anordnung von Fig. 10 zur Durchführung der anahand von Fig. 8 erläuterten Erzeugung der Abtastimpulse,

Fig. 13 Diagramme zur Erläuterung der Auswirkungen eines Ausfalls von Impulsen,

Fig. 14 eine Abänderung eines Teils der Anordnung von Fig. 10, mit der die anhand von Fig. 13 geschilderte Erscheinung beseitigt werden kann,

Fig. 15 ein Diagramm zur Erläuterung der Wirkung der Integrierschaltung in der Anordnung von Fig. 14,

Fig. 16 ein Diagramm zur Erläuterung der Wirkung des Dynamikkompressors in der Anordnung von Fig. 14,

Fig. 17 das Blockschaltbild einer abgeänderten Ausführungsform eines Teils der Anordnung von Fig. 10, mit welcher Reflexionen unterdrückt werden, und

Fig. 18 Diagramme zur Erläuterung der Funktionsweise der Anordnung von Fig. 17.

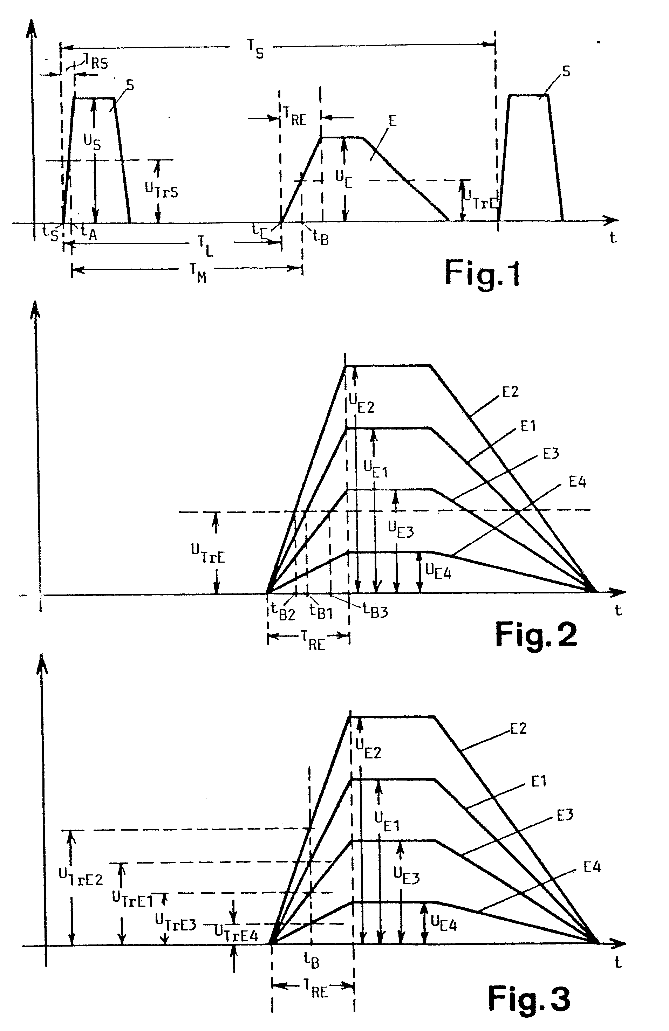

Zum besseren Verständnis der Erfindung soll zunächst das für die Impulsabstandsmessung angewendete Meßprinzip anhand der Figuren 1, 2 und 3 erläutert werden.

Als Beispiel wird angenommen, daß es sich um die Messung des Zeitabstands zwischen den Sendeimpulsen und Empfangsimpulsen bei der Entfernungsmessung nach dem Impulsrückstrahlprinzip (Impulsradarprinzip) handelt. Die verwendeten Wellen können beliebiger Art sein (Hochfrequenzwellen, Lichtwellen, Ultraschallwellen). Das Problem der Messung sehr kleiner Zeitabstände und Zeitdifferenzen — im Nano- und Subnano-Sekundenbereich — tritt in erster Linie bei der Rückstrahl-Entfernungsmessung mittels Lichtimpulsen auf. Deshalb soll die Erfindung am Beispiel der bekannten, auch »Infrarotimpulsradar« genannten Infrarotimpuls-Rückstrahl-Entfernungsmessung erläutert werden.

Von einer Infrarotquelle (z. B. von einem Infrarotfestkörperlaser) werden periodisch Lichtimpulse ausgesendet, die beim Auftreffen auf ein Hindernis (Ziel) teilweise absorbiert und teilweise reflektiert werden. Aus der Laufzeit zwischen Sendeimpuls und reflektiertem Empfangsimpuls wird der Abstand D zwischen Sender und Ziel nach der folgenden vereinfachten Formel berechnet:

$$D = \frac{1}{2} \cdot c \cdot T_L \qquad (1)$$

Darin ist c die Lichtgeschwindigkeit, und $T_L$ die Laufzeit zwischen der Aussendung des Sendeimpulses und dem Empfang des reflektierten Empfangsimpulses. Der Faktor $1/2$ ergibt sich daraus, daß der Lichtimpuls den Weg zwischen Sender und Ziel zweimal durchlaufen muß.

Fig. 1 zeigt zwei der periodisch ausgesendeten Sendeimpulse S und den aufgrund des ersten Sendeimpulses erhaltenen Empfangsimpuls E. Die Sendeperiode $T_S$ zwischen aufeinanderfolgenden Sendeimpulsen muß so groß sein, daß der Empfangsimpuls E bei der größten vorkommenden Entfernung vor der Aussendung des nächsten Sendeimpulses eintrifft.

Die Aussendung des Sendeimpulses S beginnt im Zeitpunkt $t_S$, und der Empfang des Empfangsimpulses beginnt im Zeitpunkt $t_E$. Der Zeitabstand zwischen den Zeitpunkten $t_S$ und $t_E$ ist die eigentliche Impulslaufzeit $T_L$, die der zu messenden Entfernung exakt entspricht.

Die in Wirklichkeit gemessene Zeit $T_M$ fällt nicht mit der wirklichen Laufzeit $T_L$ zusammen, weil die für die Zeitmessung verwendeten Schaltungen eine von Null verschiedene Ansprechschwelle haben und die Anstiegszeit der für die Zeitmessung verwendeten Impulse S und E ebenfalls von Null verschieden ist.

Da die Zeitmessung am Ort des Senders erfolgt, kann davon ausgegangen werden, daß die den Beginn der Zeitmessung auslösenden Sendeimpulse S eine konstante Amplitude $U_S$ haben. Die Anstiegszeit $T_{RS}$ der Sendeimpulse kann verhältnismäßig kurz gehalten werden. Wenn daher für den Start der Zeitmessung ein konstanter Triggerpegel $U_{TrS}$ festgelegt wird, der beispielsweise gleich der Hälfte der Amplitude $U_S$ der Sendeimpulse ist, so beginnt die Zeitmessung in einem Zeitpunkt $t_A$, der in einem bekannten, stets gleichbleibenden Zeitabstand hinter dem Zeitpunkt $t_S$ des Beginns der Aussendung des Sendeimpulses S liegt.

Im Gegensatz dazu ist die Amplitude $U_E$ der Empfangsimpulse E starken Schwankungen unterworfen, die durch Änderung der Absorption und der Streuung am Ziel, durch Schwankungen der Eigenschaften des Laufzeitmediums und andere Einflüsse verursacht werden. Ferner ist die Amplitude der Empfangsimpulse sehr klein, weshalb sie für die Auswertung zunächst in der Empfangselektronik auf einen ausreichenden Wert verstärkt werden müssen. Die Anstiegszeit $T_{RE}$ der Empfangsimpulse E ist, bedingt durch die Bandbreite der Empfangselektronik, größer als die Anstiegszeit $T_{RS}$ der Sendeimpulse. Die durch die Bandbreite begrenzte Anstiegszeit ist näherungsweise durch die folgende Formel gegeben:

$$T_R \approx \frac{350}{B} \qquad (2)$$

Darin ist $T_R$ die Anstiegszeit in Nanosekunden, und B die Bandbreite in Megahertz. Bei einer gegebenen Bandbreite der Empfangselektronik von 100 MHz ergibt sich also nach der Formel (2) eine Eigenanstiegszeit $T_{RI}$ der Empfangselektronik von etwa 3,5 ns. Hierzu kommt die eigene Anstiegszeit des Empfangsimpulses, die im wesentlichen gleich der Anstiegszeit $T_{RS}$ des Sendeimpulses gesetzt werden kann. Die Gesamtanstiegszeit $T_{RE}$ des Empfangsimpulses ergibt sich daraus nach der folgenden Formel:

$$T_{RE} = \sqrt{T_{RI}^2 + T_{RS}^2} \qquad (3)$$

Bei einer Anstiegszeit $T_{RS}$ der Sendeimpulse S von 1 ns und der zuvor angenommenen Bandbreite der Empfangselektronik von 100 MHz ergibt sich somit aus der Formel (3) eine Anstiegszeit $T_{RE}$ der Empfangsimpulse E von etwa 3,64 ns.

Die Beendigung der Meßzeit $T_M$ erfolgt in einem Zeitpunkt $t_B$, in welchem die Anstiegsflanke des geeignet verstärkten Empfangsimpulses E einen Triggerpegel $U_{TrE}$ erreicht. Der Zeitpunkt $t_B$ liegt in einem Zeitabstand hinter dem Zeitpunkt $t_E$, der im allgemeinen von dem Zeitabstand zwischen den Zeitpunkten $t_S$ und $t_A$ am Beginn der Meßzeit verschieden ist. Demzufolge ist die Meßzeit $T_M$ im allgemeinen von der wirklichen Laufzeit $T_L$ der Impulse verschieden. Dieser Unterschied hat keinen Einfluß auf die Meßgenauigkeit, solange die Zeitabstände $t_S - t_A$ und $t_E - t_B$ konstant bleiben; in diesem Fall ist auch die Differenz $T_M - T_L$ konstant und kann bei der Berechnung der Entfernung berücksichtigt werden.

Wie bereits erwähnt, kann davon ausgegangen werden, daß der Abstand $t_S - t_A$ am Beginn der Messung stets konstant ist. Dagegen ergeben sich am Ende der Zeitmessung infolge der Amplitudenschwankungen der Empfangsimpulse E Änderungen des Zeitabstands $t_E - t_B$, wenn mit einem konstanten Triggerpegel $U_{TrE}$ gearbeitet wird. Dies soll anhand von Fig. 2 gezeigt werden.

Fig. 2 zeigt vier verschiedene Empfangsimpulse E1, E2, E3, E4, die mit unterschiedlichen Amplituden $U_{E1}$, $U_{E2}$, $U_{E3}$, $U_{E4}$ empfangen werden, aber alle die gleiche Anstiegszeit $T_{RE}$ haben. Der Empfangsimpuls E1 entspricht dem Empfangsimpuls E von Fig. 1 in etwas größerem Maßstab. Die Anstiegsflanke des Impulses E1 schneidet die den Triggerpegel $U_{TrE}$ darstellende Linie im Zeitpunkt $t_{B1}$. Als Beispiel ist angenommen, daß der Triggerpegel $U_{TrE}$ halb so groß wie die Amplitude $U_{E1}$ des Empfangsimpulses E1 ist.

Wenn der Triggerpegel $U_{TrE}$ konstant gehalten wird und der Empfangsimpuls E2 mit einer größeren Amplitude $U_{E2}$ empfangen wird, tritt die Koinzidenz der Anstiegsflanke mit dem Triggerpegel in einem Zeitpunkt $t_{B2}$ ein, der von dem Zeitpunkt $t_{B1}$ liegt. Die Meßzeit $T_M$ ist dann entsprechend kürzer, und es ergibt sich ein Fehler in der gemessenen Entfernung, die zu kurz gemessen wird.

Umgekehrt liegt bei dem Empfangsimpuls E3, dessen Amplitude $U_{E3}$ kleiner als die Amplitude des Empfangsimpulses E1, aber größer als der Triggerpegel ist, der Koinzidenzzeitpunkt $t_{B3}$ hinter dem Zeitpunkt $t_{B1}$, so daß die Meßzeit $T_M$ entsprechend verlängert ist und wieder ein Fehler in der Entfernungsmessung besteht, wobei die Entfernung in diesem Fall zu groß gemessen wird.

Wenn schließlich ein Impuls E4 empfangen wird, dessen Amplitude $U_{E4}$ kleiner als der Triggerpegel $U_{TrE}$ ist, erfolgt überhaupt keine Auslösung der Beendigung der Meßzeit, so daß kein brauchbares Meßergebnis erhalten wird.

Es ist bekannt, die anhand von Fig. 2 erläuterten, durch die Amplitudenschwankungen der Empfangsimpulse verursachten Meßfehler dadurch zu vermeiden, daß der Triggerpegel $U_{TrE}$ nicht konstant gehalten, sondern in Abhängigkeit von der Amplitude der Empfangsimpulse verändert wird. Dies sei anhand von Fig. 3 erläutert.

Fig. 3 zeigt wieder die vier Empfangsimpulse E1, E2, E3, E4 von Fig. 2 mit den Amplituden $U_{E1}$, $U_{E2}$, $U_{E3}$, $U_{E4}$ und der gleichen Anstiegszeit $T_{RE}$. Ferner ist der Triggerpegel $U_{TrE1}$ dargestellt, der gleich der Hälfte der Amplitude $U_{E1}$ des Empfangsimpulses E1 ist und somit dem Triggerpegel $U_{TrE}$ von Fig. 2 entspricht. Beim Empfang des Impulses E1 tritt somit die Koinzidenz im Zeitpunkt $t_B$ ein, der dem Zeitpunkt $t_{B1}$ von Fig. 2 entspricht. Wenn beim Empfang des Impulses E2 für die Beendigung der Zeitmessung nicht der Triggerpegel $U_{TrE1}$ angewendet wird, sondern ein Triggerpegel $U_{TrE2}$, der gleich der Hälfte der Amplitude $U_{E2}$ des Empfangsimpulses E2 ist, so wird dieser Triggerpegel von der Anstiegsflanke des Impulses E2 wieder im Zeitpunkt $t_B$ geschnitten. Somit wird, trotz der unterschiedlichen Amplitude, beim Empfang der Impulse E1 und E2 die gleiche Meßzeit $T_M$ erhalten.

Das gleiche gilt für die Empfangsimpulse E3 und E4, wenn jeweils ein Triggerpegel $U_{TrE3}$ bzw. $U_{TrE4}$ angewendet wird, der gleich der Hälfte der Amplitude $U_{E3}$ bzw. $U_{E4}$ dieser Impulse ist. In allen Fällen tritt die Koinzidenz im gleichen Zeitpunkt $t_B$ ein. Außerdem wird auch für Impulse kleiner Amplitude, wie für den Impuls E4, ein Meßwert erhalten.

Es ist zu bemerken, daß dieses Ergebnis nicht nur dann erhalten wird, wenn der angewendete Triggerpegel gleich der Hälfte der Impulsamplitude ist, sondern auch dann, wenn der Triggerpegel in einem anderen konstanten Verhältnis zur Impulsamplitude gehalten wird. Aus Vereinfachungsgründen soll in der folgenden Beschreibung davon ausgegangen werden, daß mit einem Triggerpegel gearbeitet wird, der gleich der Hälfte der Impulsamplitude ist.

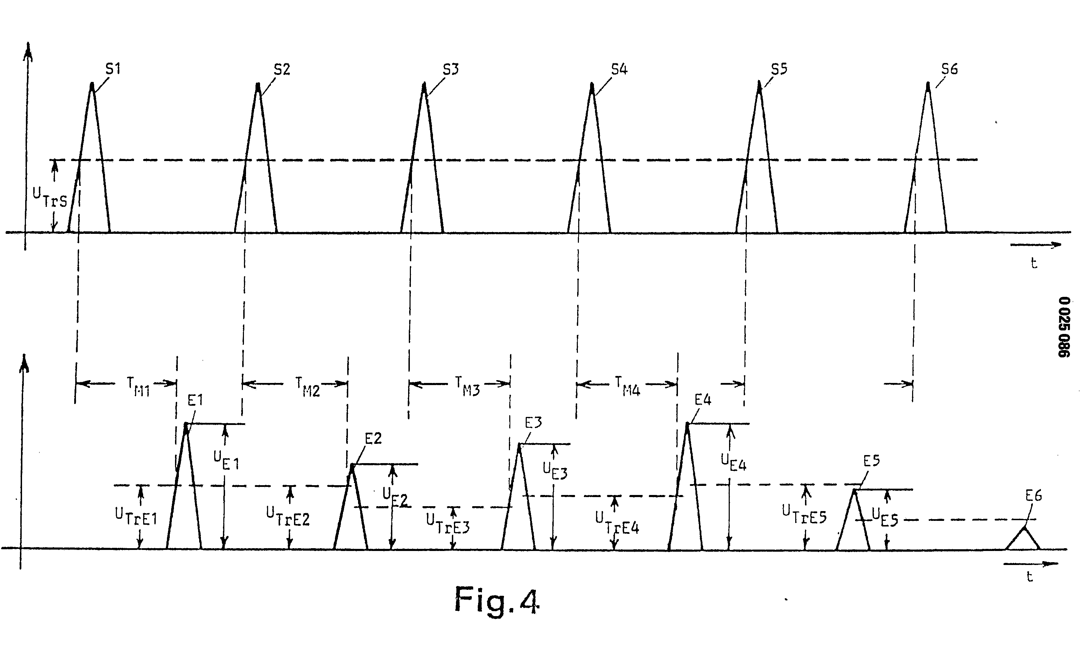

Die Anwendung des in Fig. 3 dargestellten Prinzips setzt voraus, daß der Triggerpegel bereits im Verlauf der Anstiegsflanke eingestellt ist, also bevor die Amplitude des Empfangsimpulses bekannt ist. In der Praxis wird daher die Tatsache ausgenutzt, daß die Messungen periodisch erfolgen, und es wird jeweils der Triggerpegel für den nächsten Empfangsimpuls in Abhängigkeit von der Amplitude des vorhergehenden Empfangsimpulses eingestellt. Diese Maßnahme ist brauchbar, wenn sich die Empfangsimpulsamplituden nur langsam ändern. Bei großen, schnellen Schwankungen der Amplituden der Empfangsimpulse können dagegen wieder Meßfehler auftreten oder die Messungen sogar ausfallen, wie anhand von Fig. 4 erläutert werden soll.

Im oberen Teil von Fig. 4 ist eine Folge von sechs Sendeimpulsen S1, S2, S3, S4, S5, S6 dargestellt, und im unteren Teil von Fig. 4 sind die entsprechenden, durch Reflexion am gleichen Ziel erhaltenen Empfangsimpulse E1, E2, E3, E4, E5, E6 gezeigt. Die Amplitude der Sendeimpulse ist konstant, und die Auslösung der Zeitmessung erfolgt in jeder Sendeimpulsperiode mit Hilfe des gleichen konstanten Triggerpegels $U_{TrS}$.

Dagegen ist angenommen, daß die Amplitude der Empfangsimpulse sich von Impuls zu Impuls stark ändert, und daß der Triggerpegel für jeden Empfangsimpuls gleich der Hälfte der Amplitude des vorhergehenden Empfangsimpulses eingestellt ist.

Wenn davon ausgegangen wird, daß der Triggerpegel $U_{TrE1}$ des ersten Empfangsimpulses E1 gleich der Hälfte der Amplitude $U_{E1}$ dieses Empfangsimpulses ist, weil der vorhergehende, in Fig. 4 nicht gezeigte Empfangsimpuls die gleiche Amplitude hatte, wird eine Meßzeit $T_{M1}$ erhalten, die als die richtige Meßzeit angenommen werden kann.

Für den Impuls E2 wird ein Triggerpegel $U_{TrE2}$ eingestellt, der gleich der Hälfte der Impulsamplitude $U_{E1}$ ist. Wenn, wie dargestellt, die Amplitude $U_{E2}$ des Impulses E2 wesentlich kleiner als die Amplitude $U_{E1}$ des Impulses E1 ist, wird bei gleichbleibender Zielentfernung eine Meßzeit $T_{M2}$ erhalten, die größer als die Meßzeit $T_{M1}$ ist und demzufolge mit einem Fehler behaftet ist.

Der Triggerpegel $U_{TrE3}$ für den Impuls E3 ist gleich der Hälfte der Amplitude $U_{E2}$ eingestellt. Da jedoch die Amplitude $U_{E3}$ des Impulses E3 größer als die Amplitude $U_{E2}$ ist, wird die entsprechende Meßzeit $T_{M3}$ zu kurz gemessen. Das gleiche gilt für die Meßzeit $T_{M4}$, die mit Hilfe des Impulses E4 erhalten wird, dessen Amplitude $U_{E4}$ wiederum größer als die Amplitude $U_{E3}$ ist.

Die Amplitude $U_{E5}$ des Impulses E5 ist kleiner als die Hälfte der Amplitude $U_{E4}$ des Impulses E4 und somit auch kleiner als der aufgrund des Impulses E4 eingestellte Triggerpegel $U_{TrE5}$. Somit erreicht der Impuls E5 den zugeordneten Triggerpegel nicht. Das gleiche gilt für den Empfangsimpuls E6, dessen Amplitude wiederum kleiner als die Hälfte der Amplitude $U_{E5}$ des vorhergehenden Empfangsimpulses E5 ist. Beim Empfang der Impulse E5 und E6 wird daher eine überlange Meßzeit erhalten, die das Meßergebnis vollkommen verfälscht, wenn solche Impulse nicht durch besondere Schaltungsmaßnahmen unterdrückt werden.

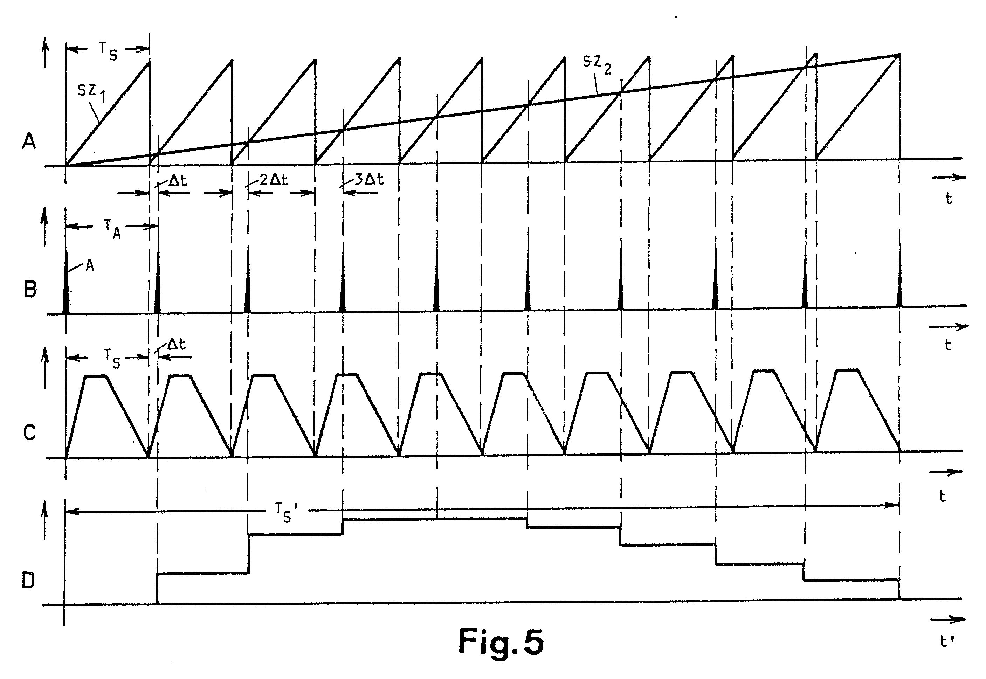

In Fig. 5 ist ein weiteres bekanntes Meßprinzip dargestellt, das insbesondere bei der Messung sehr schnell ablaufender periodischer Vorgänge angewendet wird, wie sie bei der Infrarotimpulsradartechnik vorliegen. Es handelt sich um das bekannte »Sampling-Verfahren«.

Bekanntlich besteht das Sampling-Verfahren darin, daß aus jedem der periodisch aufeinanderfolgenden Vorgänge ein Abtastwert entnommen wird, wobei die zeitliche Lage der Abtastwerte in bezug auf den Beginn der Periode von Periode zu Periode geringfügig verschoben ist. Diese Abtastung wird durch Abtastimpulse gesteuert, deren Periode um eine festgelegte, sehr kleine Zeitdifferenz größer ist als die Periode der abzutastenden Vorgänge. Jeder Abtastwert wird bis zur nächsten Abtastung gespeichert. Die aneinandergefügten Abtastwerte ergeben somit eine Abbildung der abgetasteten Vorgänge, jedoch in einem um den Zeittransformationsfaktor gedehnten Zeitmaßstab.

Es handelt sich also um eine Art elektronische stroboskopische Abtastung der periodischen Vorgänge.

Zur Erläuterung des Sampling-Verfahrens sind im Diagramm C von Fig. 5 Signale gleicher Kurvenform dargestellt, die sich mit der Periode $T_S$ regelmäßig wiederholen. Diese Signale werden durch die im Diagramm B dargestellten Abtastimpulse A abgetastet, deren Periode $T_A$ sich um eine kleine Zeitdifferenz $\Delta t$ von der Periode $T_S$ der abzutastenden Signale unterscheidet. Im Fall von Fig. 5 gilt:

$$T_A = T_S + \Delta t.$$

Mit Hilfe der Abtastimpulse A des Diagramms B wird aus jeder der aufeinanderfolgenden Signalkurven des Diagramms C ein Abtastwert entnommen, wobei die Lage der Abtastwerte von einer Periode zur folgenden um den Betrag $\Delta t$ verschieden ist. Wenn also der erste Abtastwert mit dem Beginn der Signalperiode zusammenfällt, liegt der zweite Abtastwert um den Zeitabstand $\Delta t$ nach dem Beginn der Signalperiode, der dritte Abtastwert um $2\Delta t$ nach dem Beginn der Signalperiode usw.

Es ist zu bemerken, daß die Zeitdifferenz $\Delta t$ in Fig. 5 der Deutlichkeit wegen übertrieben groß dargestellt ist; in Wirklichkeit ist diese Zeitdifferenz sehr klein. Sie beträgt beispielsweise 1/400 000 der Periode $T_S$, so daß die aufeinanderfolgenden Abtastwerte sehr nahe beieinanderliegenden Punkten der Signalkurve entsprechen und entsprechend viele (beim angegebenen Beispiel 400 000) Abtastimpulse zur Abtastung einer vollständigen Signalperiode erforderlich sind.

Die nacheinander erhaltenen Abtastwerte werden jeweils bis zum nächsten Abtastwert gespeichert, wodurch die im Diagramm D von Fig. 5 dargestellte Treppenkurve erhalten wird, die eine der Signalkurven des Diagramms C in stark gedehntem Zeitmaßstab wiedergibt. Da in Wirklichkeit die Anzahl der Abtastpunkte sehr groß ist, wird die Treppenkurve des Diagramms D mit einer sehr feinen Abstufung erhalten, welche eine Periode der Kurve des Diagramms C mit guter Annäherung getreu abbildet.

Die Zeitdehnung entspricht der Anzahl der für eine vollständige Abbildung einer Signalperiode verwendeten Abtastwerte, bei dem zuvor angegebenen Zahlenbeispiel also 400 000 : 1. Wenn man die Periodendauer des zeittransformierten Signals mit $T'_S$ bezeichnet, so gilt:

$$T'_S = k \cdot T_S.$$

Den Faktor k bezeichnet man als den Zeittransformationsfaktor.

Das durch die Abtastung erhaltene zeittransformierte Signal, das im Diagramm D von Fig. 5 dargestellt ist, kann in gleicher Weise wie die abgetasteten Signale ausgewertet werden, wenn der Zeittransformationsfaktor berücksichtigt wird. Infolge der Zeitdehnung ist es jedoch möglich, mit sehr viel langsamer arbeitenden Schaltungen und Geräten und insbesondere mit sehr viel geringerer Bandbreite zu arbeiten.

Das Diagramm A von Fig. 5 zeigt ein bekanntes Verfahren zur Erzeugung von Abtastimpulsen, deren Periode sich um eine konstante Zeitdifferenz $\Delta t$ von einer vorgegebenen Periode (im vorliegenden Fall also der Periode $T_S$) unterscheidet. Zu diesem Zweck werden zwei lineare Sägezahnspannungen $SZ_1$ und $SZ_2$ mit sehr unterschiedlicher Steigerung erzeugt. Die Sägezahnspannung $SZ_1$ hat die Periode $T_S$ der abzutastenden Signale, und die Sägezahnspannung $SZ_2$ hat eine sehr viel größere Periode. Die beiden Sägezahnspannungen werden an den Eingang eines Komparators angelegt, der jeweils bei Feststellung der Koinzidenz der ansteigenden Flanken die Erzeugung eines Abtastimpulses auslöst. Das Diagramm A läßt unmittelbar erkennen, daß die Koinzidenzzeitpunkte in den aufeinanderfolgenden Perioden der Sägezahnspannung $SZ_1$ jeweils im Zeitabstand $\Delta t$, $2\Delta t$, $3\Delta t$ usw. nach dem Beginn der Periode liegen. Das entspricht genau der gewünschten zeitlichen Lage der Abtastimpulse des Diagramms B.

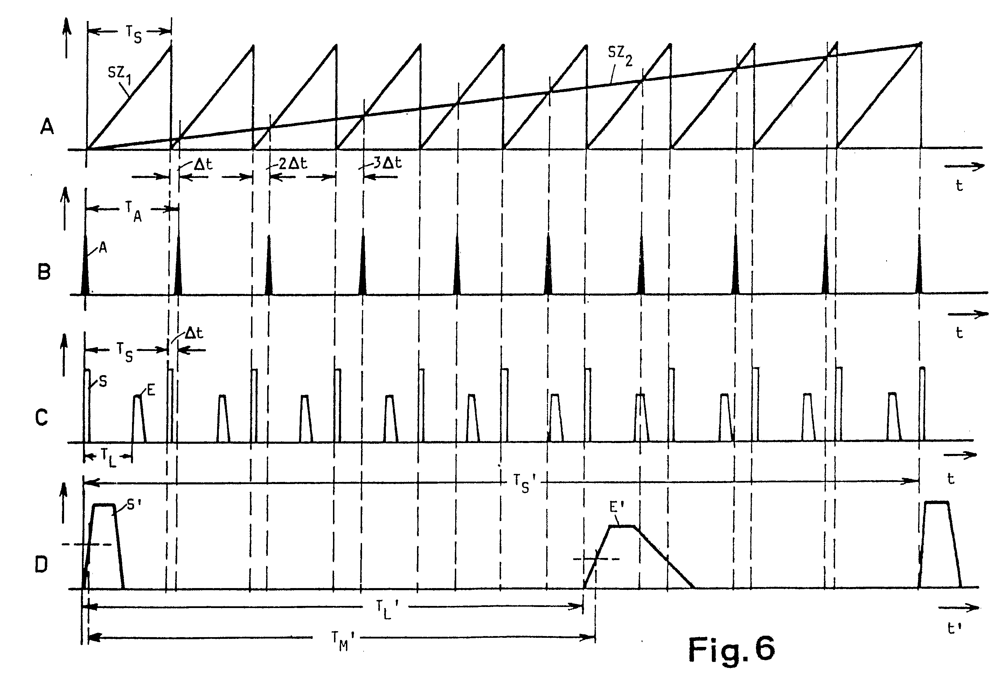

Das beschriebene Sampling-Verfahren läßt sich auch für die Impulsabstandsmessung zwischen den Sendeimpulsen und Empfangsimpulsen bei der Rückstrahl-Entfernungsmessung anwenden, wie in Fig. 6 dargestellt ist. Die Diagramme A und B von Fig. 6 entsprechen den Diagrammen A und B von Fig. 5. Die im Diagramm C von Fig. 6 dargestellten abzutastenden Vorgänge sind jedoch nicht mehr Signalkurven, die sich über die ganze Dauer der Periode erstrecken, sondern die mit der Sendeperiode $T_S$ ausgesendeten Sendeimpulse S und die innerhalb jeder Periode empfangenen Empfangsimpulse E des Rückstrahl-Entfernungsmeßverfahrens, wie sie in Fig. 1 für eine Periode dargestellt sind.

Die Abtastung der aufeinanderfolgenden Sendeperioden der Dauer $T_S$ erfolgt mit Hilfe der Abtastimpulse des Diagramms B in der zuvor geschilderten Weise. Im Diagramm D ist das durch die Abtastung erhaltene zeitgedehnte Signal dargestellt. Es enthält das um den Zeittransformationsfaktor gedehnte Abbild $S'$ des Sendeimpulses S und das um den Zeittransformationsfaktor gedehnte Abbild $E'$ der Empfangsimpulse E. Die Laufzeit $T_L$ zwischen Sendeimpuls und Empfangsimpuls ist gleichfalls um den Zeittransformationsfaktor gedehnt, wie bei $T'_L$ dargestellt ist. Die anhand der Figuren 1 bis 4 erläuterte Messung des Abstandes zwischen Sendeimpuls und Empfangsimpuls kann an den zeitgedehnten Impulsen $S'$, $E'$ vorgenommen werden, wodurch die zeitgedehnte Meßzeit $T'_M$ erhalten wird.

Wenn beispielsweise mit einer Sendeimpulsperiode $T_S = 5$ µs (entsprechend einer Sendefolgefrequenz $f_S = 200$ kHz) gearbeitet wird und der zuvor als Beispiel angegebene Zeittransformationsfaktor 400 000 : 1 angenommen wird, beträgt die Sendeimpulsperiode im zeittransformierten Bereich $T'_S = 2$ s. Wenn eine Entfernung D = 30 m gemessen wird, entspricht dies im Echtzeitbereich einer Impulslaufzeit $T_L = 2 \cdot 100$ ns. Im zeittransformierten Bereich ergibt dies eine Impulslaufzeit $T'_L = 2 \cdot 40$ ms.

An den durch die Abtastung erhaltenen zeittransformierten Impulsen $S'$ und $E'$ kann also der Impulsabstand auf sehr viel einfachere Weise und mit größerer Genauigkeit gemessen werden als im Echtzeitbereich.

Für die anhand der Figuren 2, 3 und 4 geschilderten Auswirkungen von Amplitudenschwankungen der Empfangsimpulse auf die Triggerpegeleinstellung wirkt sich aber das Sampling-Verfahren nachteilig aus. Die Einstellung des Triggerpegels erfolgt nämlich aufgrund des Spitzenwerts eines zeittransformierten Empfangsimpulses $E'$ für den nächsten zeittransformierten Empfangsimpuls $E'$. Infolge der Zeitdehnung werden bei dem zuvor angegebenen Zahlenbeispiel die Empfangsimpulse etwa im Zeitabstand der zeittransformierten Sendeperiode $T'_S$, also im Zeitabstand von 2 s erhalten. Die Wahrscheinlichkeit, daß sich die Amplitude der Empfangsimpulse innerhalb dieses zeittransformierten Zeitabstands erheblich ändert, ist wesentlich größer als eine erhebliche Amplitudenänderung innerhalb einer Sendeperiode des Echtzeitbereichs.

Obwohl die Anwendung des Sampling-Verfahrens gerade beim Infrarotimpulsradar wegen der kurzen Laufzeiten und Laufzeitdifferenzen aus verschiedenen Gründen sehr erwünscht und vorteilhaft ist, steht dieser Anwendung das Problem der Triggerpegeloptimierung in erhöhtem Maße entgegen.

Nachstehend wird ein Verfahren beschrieben, das gerade unter der Ausnutzung der Vorteile des Sampling-Verfahrens eine optimale Einstellung des Triggerpegels ermöglicht.

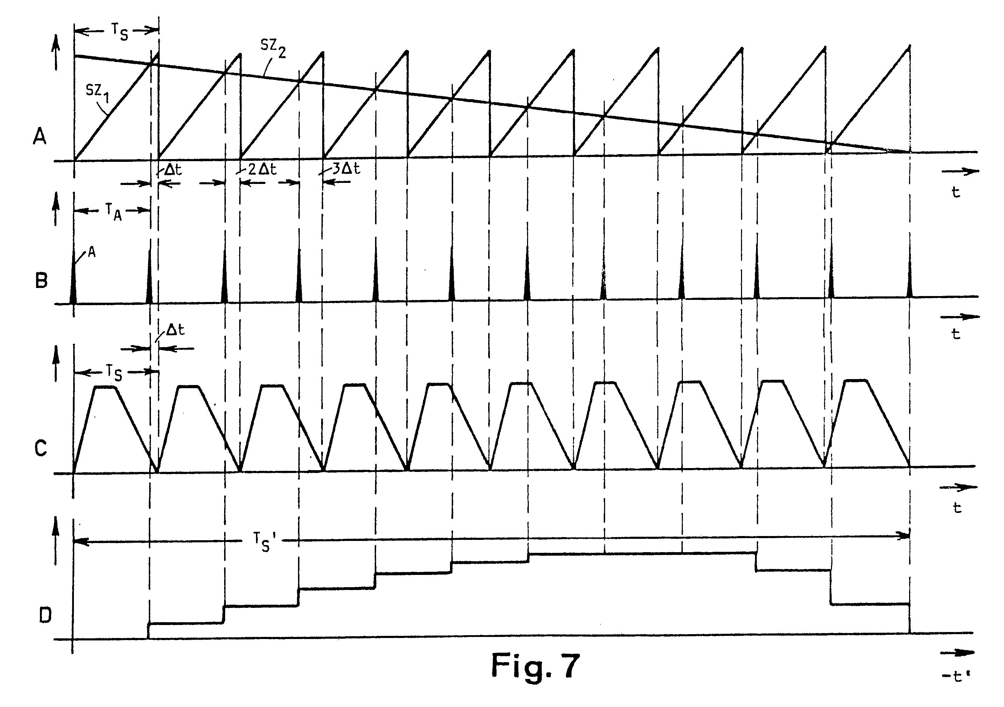

Dabei wird eine abgeänderte Ausführungsform des Sampling-Verfahrens angewendet, die in Fig. 7 dargestellt ist.

Im Diagramm C von Fig. 7 ist zum besseren Verständnis des angewendeten Abtastprinzips wieder das gleiche abzutastende Signal dargestellt, wie im Diagramm C von Fig. 5. Dieses Signal hat wieder die gleiche Periode $T_S$.

Die Abtastung erfolgt jedoch in diesem Fall mit Hilfe von Abtastimpulsen A (Diagramm B von Fig. 7), deren Folgeperiode um einen kleinen Zeitabstand $\Delta t$ kleiner als die Periode $T_S$ des abzutastenden Signals ist. In diesem Fall gilt also die Beziehung:

$$T_A = T_S - \Delta t$$

Demzufolge liegt in jeder Periode $T_S$ des abzutastenden Signals der Abtastzeitpunkt um die Zeitdifferenz $\Delta t$ früher als der Abtastzeitpunkt in der vorhergehenden Periode.

Das durch diese Abtastung erhaltene zeittransformierte Signal ist im Diagramm D von Fig. 7 gezeigt. Es ist unmittelbar zu erkennen, daß dieses zeittransformierte Signal eine Periode des abgetasteten Signals zwar wiederum naturgetreu, aber spiegelverkehrt wiedergibt. Um diese Invertierung des zeittransformierten Bereichs anzudeuten, ist der Zeitmaßstab negativ $(-t')$ bezeichnet.

Im Diagramm A von Fig. 7 ist eine Möglichkeit gezeigt, wie die Abtastimpulse des Diagramms B erhalten werden können. Dies geschieht wieder dadurch, daß jeweils im Zeitpunkt der Koinzidenz von zwei Sägezahnsignalen sehr unterschiedlicher Periodendauer ein Abtastimpuls erzeugt wird. Das schnelle Sägezahnsignal $SZ_1$ hat wieder die gleiche Periode $T_S$ wie das abzutastende Signal und den gleichen Verlauf mit ansteigenden Flanken wie in Fig. 5 und 6. Das langsame Sägezahnsignal $SZ_2$ hat dagegen die umgekehrte Neigung wie im Fall von Fig. 5 und 6. Es ist unmittelbar zu erkennen, daß die Koinzidenzzeitpunkte in den aufeinanderfolgenden Perioden der Sägezahnspannung $SZ_1$ jeweils im Zeitabstand $\Delta t$, $2\Delta t$, $3\Delta t$ usw. vor dem Ende der Periode liegen. Auf diese Weise werden Abtastimpulse erhalten, deren Folgeperiode $T_A$ um $\Delta t$ kleiner als die Periode $T_S$ der abzutastenden Signale ist.

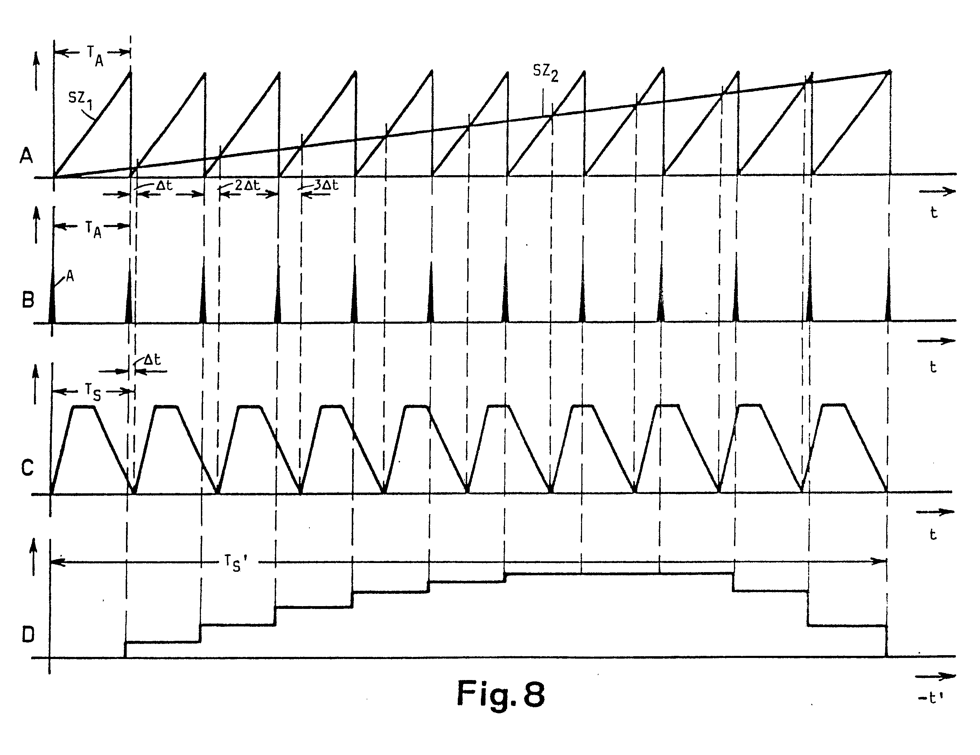

Eine andere Möglichkeit zur Erzeugung von Abtastimpulsen, deren Periode um eine kleine Zeitdifferenz $\Delta t$ kleiner als die Periode der abzutastenden Signale ist, ist in Fig. 8 dargestellt. Die Diagramme B, C, D von Fig. 8 stimmen mit den Diagrammen B, C bzw. D von Fig. 7 überein. Im Diagramm A von Fig. 8 sind wieder zwei Sägezahnsignale $SZ_1$ und $SZ_2$ dargestellt, die, wie im Fall von Fig. 5, im gleichen Sinne ansteigende Flanken haben. In diesem Fall ist aber die Periode des schnellen Sägezahnsignals $SZ_1$ nicht gleich der Periode $T_S$ der abzutasten-

den Signale, sondern gleich der Periode $T_A$ der Abtastimpulse; jeder Abtastimpuls wird also im Zeitpunkt des Beginns einer ansteigenden Flanke des schnellen Sägezahnsignals $SZ_1$ erzeugt. Dagegen fallen die Koinzidenzzeitpunkte zwischen dem schnellen Sägezahnsignal $SZ_1$ und dem langsamen Sägezahnsignal $SZ_2$ jeweils mit dem Beginn einer Periode des abzutastenden Signals des Diagramms C zusammen. In diesem Fall ist also die Periode $T_S$ des abzutastenden Signals um $\Delta t$ größer als die Periode $T_A$ der Abtastimpulse. Dies entspricht genau der oben angegebenen zeitlichen Beziehung:

$$T_A = T_S - \Delta t.$$

Das in Fig. 8 dargestellte Verfahren eignet sich besonders für den Fall, daß die Periode des abzutastenden Signals nicht durch äußere Bedingungen festgelegt ist, sondern durch die Meßanordnung bestimmt werden kann. Dies gilt beispielsweise für den Fall der Rückstrahl-Entfernungsmessung, bei welcher die Sendeimpulse zu beliebig wählbaren Zeitpunkten ausgelöst werden können.

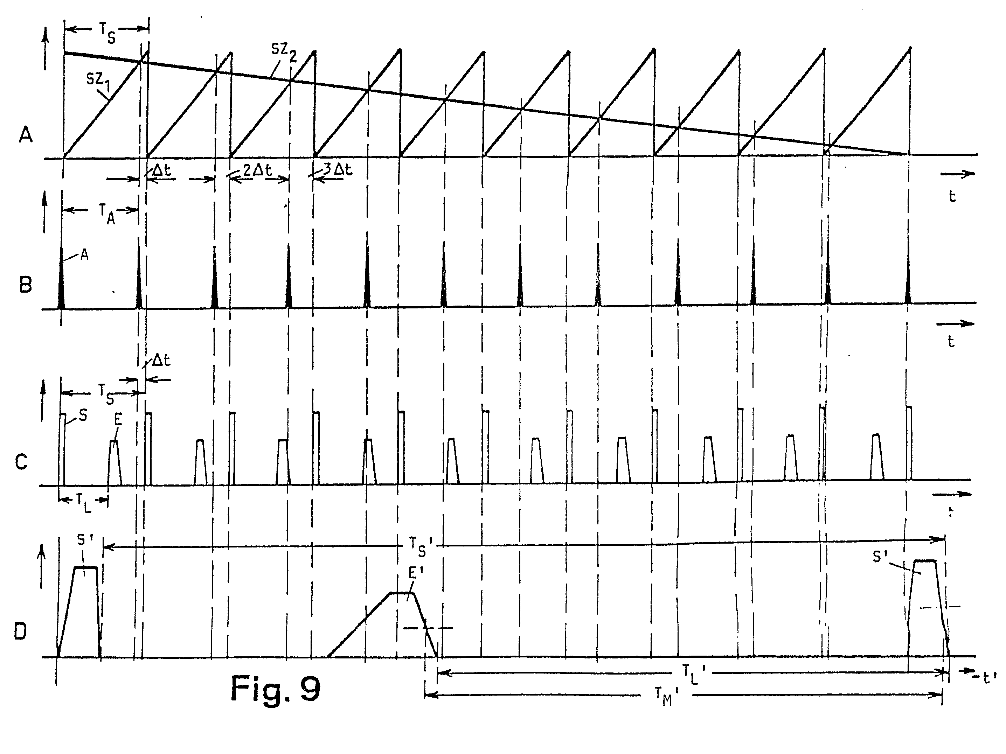

In Fig. 9 ist in ähnlicher Weise wie in Fig. 6 dargestellt, wie sich das anhand der Figur 7 erläuterte »zeitinvertierte Sampling-Verfahren« auf die Impulsabstandsmessung bei der Rückstrahl-Entfernungsmessung auswirkt. Die Diagramme A und B von Fig. 9 entsprechen den Diagrammen A und B von Fig. 7. Im Diagramm C von Fig. 9 sind die gleichen Signale wie im Diagramm C von Fig. 6 dargestellt, also die mit der Sendeperiode $T_S$ ausgesendeten Sendeimpulse S und die innerhalb jeder Periode empfangenen Empfangsimpulse E.

Das Diagramm D zeigt das durch die zeitinvertierte Abtastung erhaltene zeittransformierte Signal. Es ist zu erkennen, daß nicht nur die einzelnen zeittransformierten Impulse S' und E' spiegelverkehrt wiedergegeben werden, sondern die ganze Periode, so daß insbesondere auch die gegenseitigen zeitlichen Lagen der Impulse umgekehrt sind. Der zeittransformierte Empfangsimpuls E' erscheint somit vor dem zeittransformierten Sendeimpuls S', und die Vorderflanken der Impulse des Echtzeitbereichs entsprechen den Rückflanken der zeittransformierten Impulse. Um die gleichen Verhältnisse wie im Fall von Fig. 6 zu erhalten, muß also die zeittransformierte Meßzeit $T'_M$ an den Rückflanken der zeittransformierten Impulse E' und S' gemessen werden.

Das gleiche Ergebnis wird natürlich erhalten, wenn die Abtastimpulse A in der in Fig. 8 dargestellten Weise erzeugt werden.

Aus Fig. 9 ist unmittelbar zu erkennen, daß die für die Triggerpegeleinstellung erforderliche Information über den Spitzenwert jedes Impulses vor der Rückflanke vorhanden ist, die der Anstiegsflanke des Echtzeitimpulses entspricht und für die Zeitmessung verwendet wird. Es ist daher möglich, für jeden Impuls den Triggerpegel aufgrund des zuvor festgestellten Spitzenwerts des gleichen Impulses einzustellen. Dies kann mit einer sehr einfachen Schaltung geschehen und ergibt automatisch den optimalen Triggerpegel für jeden Impuls.

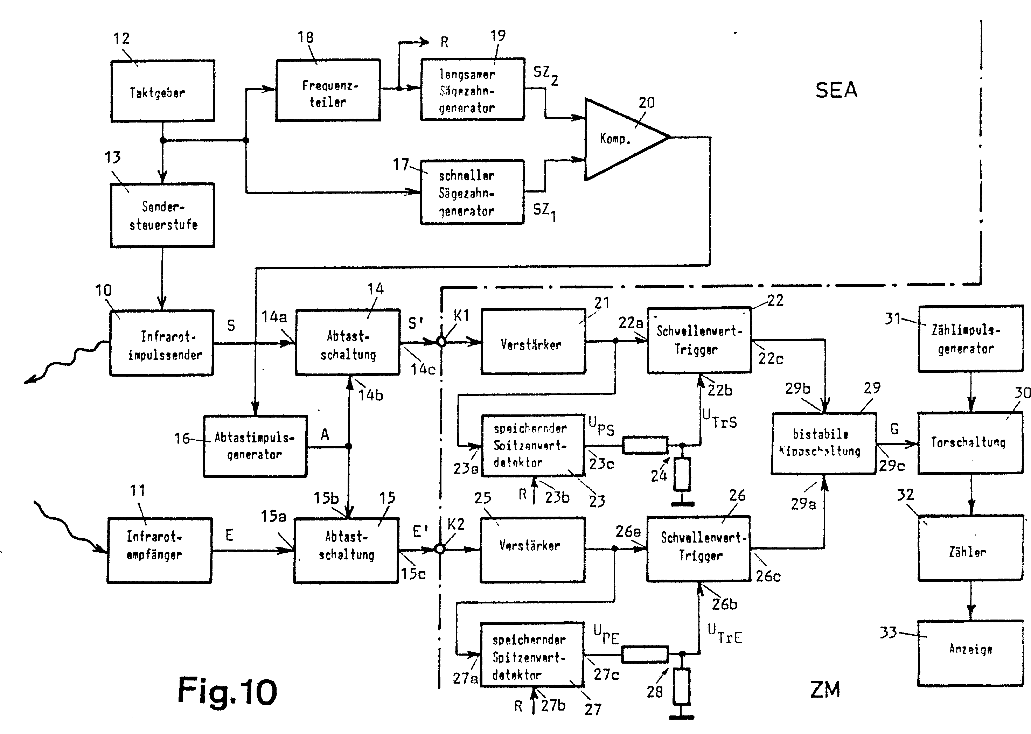

Fig. 10 zeigt eine Anordnung zur Durchführung der anhand von Fig. 9 erläuterten Impulsabstandsmessung unter Anwendung des »zeitinvertierten Sampling-Verfahrens« bei einem Infrarotimpulsradar.

Der besseren Übersicht wegen ist die Anordnung von Fig. 10 in zwei durch eine strichpunktierte Linie voneinander getrennte Teilanordnungen SEA und ZM unterteilt, die an den Klemmen K1, K2 miteinander verbunden sind. Die Teilanordnung SEA ist die Sende-, Empfangs- und Abtastanordnung, welche die Infrarotimpulse erzeugt und aussendet, die am Ziel reflektierten Echoimpulse empfängt, die Abtastimpulse erzeugt und die Sende- und Empfangsimpulse nach dem zeitinvertierten Sampling-Verfahren abtastet, so daß sie an der Klemme K1 die zeittransformierten Sendeimpulse S' und an der Klemme K2 die zeittransformierten Empfangsimpulse E' des Diagramms D von Fig. 9 zur Verfügung stellt.

Die Teilanordnung ZM ist die Zeitmeßanordnung, die den Zeitabstand $T'_M$ zwischen den Rückflanken der zeittransformierten Impulse E' und S' mißt.

Die Sende-, Empfangs- und Abtastanordnung SEA enthält einen Infrarotimpulssender 10, der periodische Infrarotimpulse zu einem Ziel aussendet, dessen Entfernung gemessen werden soll, und einen Infrarotempfänger 11, der die am Ziel reflektierten Infrarotimpulse empfängt. Die Aussendung der Impulse wird durch einen Taktgeber 12 synchronisiert, der Taktimpulse mit der gewünschten Sendeperiode $T_S$ liefert, die eine Sendersteuerstufe 13 ansteuern. Die Sendersteuerstufe 13 erzeugt für jeden Taktimpuls einen elektrischen Auslöseimpuls, der die Aussendung eines Infrarotimpulses durch den Sender 10 auslöst. Synchron mit jedem ausgesendeten Infrarotimpuls gibt der Sender 10 an einem mit dem Signaleingang 14a einer Abtastschaltung 14 verbundenen Ausgang einen elektrischen Sendeimpuls S ab. Der die Empfangsimpulse E liefernde Ausgang des Infrarotempfängers 11 ist mit dem Signaleingang 15a einer Abtastschaltung 15 verbunden. Die Steuereingänge 14b, 15b der Abtastschaltungen 14, 15 sind mit dem Ausgang eines Abtastimpulsgenerators 16 verbunden.

Die Abtastschaltungen 14 und 15 sind von gleicher Art, beispielsweise sogenannte Momentanspeicher (»Sample & Hold«), die jedesmal dann, wenn an ihrem Steuereingang 14b, 15b ein kurzer Abtastimpuls angelegt wird, die Ladespannung eines Speicherkondensators gleich dem Momentanwert des am Signaleingang 14a, 15a anliegenden Signals machen und diese Ladespannung bis zum Erscheinen des nächsten Abtastimpulses festhalten. Die Ladespannung des Speicherkondensators steht am Ausgang 14c bzw. 15c jeder Abtastschaltung 14, 15 dauernd zur Verfügung.

Die vom Taktgeber 12 gelieferten Taktimpulse werden außer an die Sendersteuerstufe 13 auch an den Synchronisiereingang eines schnellen Sägezahngenerators 17 und an den Eingang eines Frequenzteilers 18 angelegt. Der Ausgang des Frequenzteilers 18 ist mit dem Synchronisiereingang eines langsamen Sägezahngenerators 19 verbunden, und der Teilerfaktor des Frequenzteilers 18 ist entsprechend dem gewünschten Zeittransformationsfaktor so bemessen, daß die Periode des langsamen Sägezahngenerators 19 sehr viel größer als die Periode des schnellen Sägezahngenerators 17 ist. Ferner sind die Sägezahngeneratoren 17 und 19 so ausgeführt, daß ihre schrägen Flanken gegenläufig sind, daß also die schräge Flanke des langsamen Sägezahngenerators abfällt, wenn die schräge Flanke des schnellen Sägezahngenerators 17 ansteigt. Somit entsprechen die Ausgangssignale der Sägezahngeneratoren 17 und 19 den im Diagramm A von Fig. 9 dargestellten Sägezahnsignalen $SZ_1$ und $SZ_2$.

Die Ausgänge der beiden Sägezahngeneratoren 17 und 19 sind mit den beiden Eingängen eines Komparators 20 verbunden, der so ausgeführt ist, daß er jedesmal dann ein Ausgangssignal liefert, wenn die an seinen beiden Eingängen anliegenden Signale gleich groß sind. Der Ausgang des Komparators 20 ist mit einem Auslöseeingang des Abtastimpulsgenerators 16 verbunden, so daß dieser synchron mit jedem Ausgangssignal des Komparators 20 einen Abtastimpuls A liefert.

Es ist unmittelbar zu erkennen, daß die Sende-, Empfangs- und Abtastanordnung SEA die anhand von Fig. 9 erläuterte Wirkungsweise ergibt, so daß die Abtastschaltung 14 an ihrem Ausgang 14c, der mit der Klemme K1 verbunden ist, die zeittransformierten Sendeimpulse S' liefert und die Abtastschaltung 15 an ihrem Ausgang 15c, der mit der Klemme K2 verbunden ist, die zeittransformierten Empfangsimpulse E' liefert. Diese zeittransformierten Impulse entsprechen dem Diagramm D von Fig. 9, d. h., daß ihre zeitliche Lage invertiert ist und jeder zeittransformierte Empfangsimpuls E' zeitlich vor dem zugehörigen zeittransformierten Sendeimpuls S' erscheint.

In der Zeitmeßanordnung ZM ist an die Klemme K1 der Eingang eines Verstärkers 21 angeschlossen, dessen Ausgang einerseits mit dem Signaleingang 22a eines Schwellenwert-Triggers 22 und andererseits mit dem Signalseingang 23a eines speichernden Spitzenwertdetektors 23 verbunden ist. Der Schwellenwert-Trigger 22 hat außerdem einen Triggerpegeleingang 22b, und er ist so ausgeführt, daß er jedesmal dann ein vorbestimmtes Ausgangssignal am Ausgang 22c liefert, wenn das am Eingang 22a anliegende Signal unter dem am Triggerpegeleingang 22b anliegenden Triggerpegel fällt; dieses Ausgangssignal am Ausgang 22c kann beispielsweise dem Übergang der Ausgangsspannung vom Wert »0« zum Wert »1« entsprechen.

Der speichernde Spitzenwertdetektor hat einen Rückstelleingang 23b, so daß der gespeicherte Spannungswert durch Anlegen eines Rückstellimpulses R auf einen Anfangswert (der auch Null sein kann) zurückgestellt wird. Diese Rückstellung erfolgt am Beginn jedes Abtastzyklus; zu diesem Zweck kann als Rückstellimpuls R beispielsweise der Ausgangsimpuls des Frequenzteilers 18 verwendet werden, der eine neue Periode des langsamen Sägezahngenerators 19 auslöst. Der speichernde Spitzenwertdetektor 23 ist so ausgebildet, daß die an seinem Ausgang 23c abgegebene Spannung $U_{PS}$ stets gleich der am Eingang 23a anliegenden Spannung ist, solange der Augenblickswert dieser Spannung größer als jeder seit der letzten Rückstellung erreichte Augenblickswert ist, wogegen die Ausgangsspannung $U_{PS}$ auf dem jeweils erreichten Höchstwert bleibt, wenn die Eingangsspannung unter einen früher erreichten Wert abfällt. Somit entspricht die Ausgangsspannung $U_{PS}$ des Spitzenwertdetektors 23 jeweils dem höchsten im Verlauf eines Abtastzyklus erreichten Wert der Eingangsspannung.

An den Ausgang 23c des speichernden Spitzenwertdetektors 23 ist ein Spannungsteiler 24 angeschlossen, der beispielsweise aus zwei Widerständen besteht, die bei dem beschriebenen Ausführungsbeispiel gleich groß sind. Der Abgriff des Spannungsteilers 24 ist mit dem Triggerpegeleingang 22b des Schwellenwert-Triggers 22 verbunden. Somit liegt am Schwellenwert-Trigger 22 die halbe Ausgangsspannung $U_{PS}/2$ des Spitzenwertdetektors 23 als Triggerpegel $U_{TrS}$ an.

An die Klemme K2 ist in der Zeitmeßanordnung ZM eine Schaltungsanordnung angeschlossen, die der soeben beschriebenen, an die Klemme K1 angeschlossenen Schaltungsanordnung völlig gleich ist. Zu dieser Schaltungsanordnung gehört ein Verstärker 25, dessen Eingang mit der Klemme K2 verbunden ist, und an dessen Ausgang einerseits der Signaleingang 26a eines Schwellenwert-Triggers 26 und andererseits der Signaleingang 27a eines speichernden Spitzenwertdetektors 27 angeschlossen sind. Der Schwellenwert-Trigger 26 hat einen Triggerpegeleingang 26b und liefert am Ausgang 26c ein Signal, wenn seine Eingangsspannung am Signaleingang 26a unter den am Triggerpegeleingang 26b liegenden Triggerpegel fällt. Der speichernde Spitzenwertdetektor 27 hat einen Rückstelleingang 27b, an den die Rückstellimpulse R angelegt werden, und er liefert an seinem Ausgang 27c eine Spannung $U_{PE}$, die gleich dem seit der letzten Rückstellung erreichten Größtwert der am Signaleingang 27a anliegenden Spannung ist. An den Ausgang 27c des Spitzenwertdetektors 27 ist ein Spannungsteiler 28 aus zwei gleichen Widerständen angeschlossen, dessen Abgriff mit dem Triggerpegeleingang 26b des Schwellenwert-Triggers 26 verbunden ist. Somit liegt am Triggerpegeleingang 26b die halbe Aus-

gangsspannung $U_{PE}/2$ des speichernden Spitzenwertdetektors 27 als Triggerpegel $U_{TrE}$ an.

Der Ausgang 26c des Schwellenwert-Triggers 26 ist mit dem Setzeingang 29a einer bistabilen Kippschaltung 29 verbunden, und der Ausgang 22c des Schwellenwert-Triggers 22 ist mit dem Rücksetzeingang 29b der bistabilen Kippschaltung 29 verbunden. Der Ausgang 29c der bistabilen Kippschaltung 29 ist mit dem Steuereingang einer Torschaltung 30 verbunden, deren Signaleingang an den Ausgang eines Zählimpulsgenerators 31 angeschlossen ist. Der Ausgang der Torschaltung 30 ist mit dem Zähleingang eines Zählers 32 verbunden, dessen Zählerstand zu einer Anzeigevorrichtung 33 übertragen werden kann.

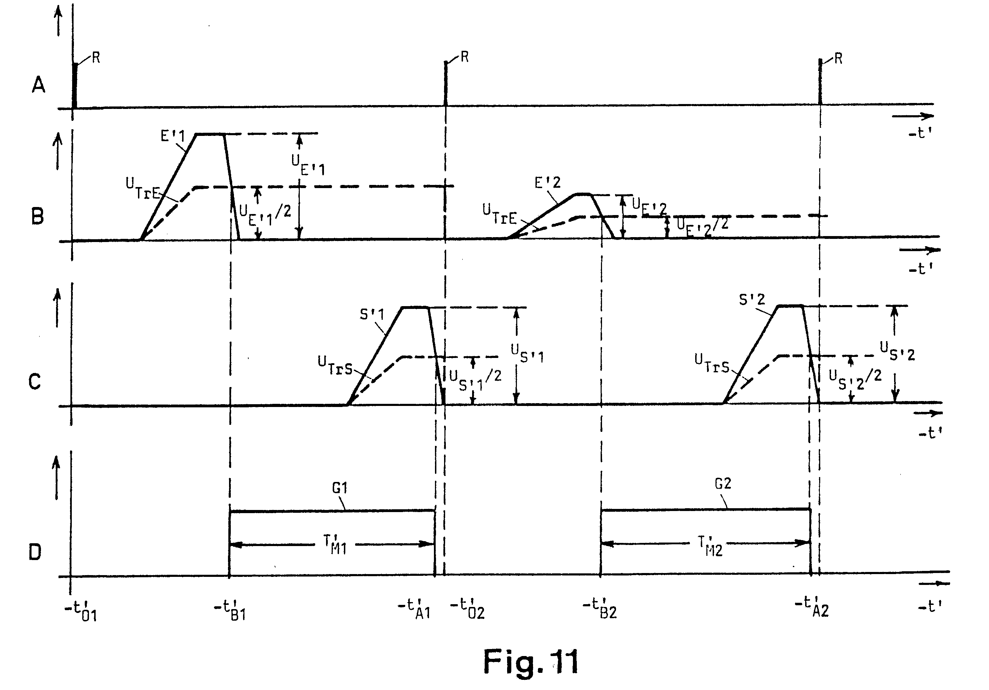

Die Funktionsweise der Zeitmeßanordnung ZM von Fig. 10 soll anhand der Diagramme von Fig. 11 erläutert werden.

In Fig. 11 sind im zeittransformierten Bereich $-t'$ zwei vollständige Abtastzyklen dargestellt, die jeweils durch einen Rückstellimpuls R eingeleitet werden, wie im Diagramm A von Fig. 11 gezeigt ist.

In jedem Abtastzyklus wird ein zeittransformierter Empfangsimpuls $E'1$, $E'2$ (Diagramm B) und ein zeittransformierter Sendeimpuls $S'1$, $S'2$ (Diagramm C) erhalten. Wie zuvor erläutert wurde, tritt jeder zeittransformierte Empfangsimpuls $E'$ in dem betreffenden Abtastzyklus früher auf als der zugehörige zeittransformierte Sendeimpuls $S'$.

Als Beispiel ist angenommen, daß der im ersten Abtastzyklus erhaltene zeittransformierte Empfangsimpuls $E'1$ eine Amplitude $U_{E'1}$ hat, die wesentlich größer als die Amplitude $U_{E'2}$ des zeittransformierten Empfangsimpulses $E'2$ im folgenden Abtastzyklus ist. Dagegen kann davon ausgegangen werden, daß die Amplituden $U_{S'1}$, $U_{S'2}$ der Sendeimpulse $S'1$, $S'2$ (Diagramm C) die gleiche Amplitude haben.

Im Diagramm B ist ferner durch die gestrichelte Linie $U_{TrE}$ der am Eingang 26b des Schwellenwert-Triggers 26 anliegende Triggerpegel dargestellt, der gleich der halben Ausgangsspannung des speichernden Spitzenwertdetektors 27 ist. In gleicher Weise ist im Diagramm C durch die gestrichelte Kurve $U_{TrS}$ der am Eingang 22b des Schwellenwert-Triggers 22 anliegende Triggerpegel dargestellt, der gleich der halben Ausgangsspannung des speichernden Spitzenwertdetektors 23 ist.

Das Diagramm D zeigt die vom Ausgang 29c der bistabilen Kippschaltung 29 gelieferten Torimpulse G, die an den Steuereingang der Torschaltung 30 angelegt sind.

Der erste Meßzyklus beginnt im Zeitpunkt $t'_{01}$ mit einem Rückstellimpuls R. Durch diesen Rückstellimpuls werden die speichernden Spitzenwertdetektoren 23 und 27 gelöscht, so daß die Triggerpegelspannungen $U_{PE}/2$ und $U_{PS}/2$ zunächst den Wert Null haben.

Wenn im Verlauf des Abtastzyklus die Abtastung der Echtzeit-Empfangsimpulse beginnt, steigt die den zeittransformierten Empfangsimpuls $E'1$ darstellende Ausgangsspannung des Verstärkers 25 an, und die Ausgangsspannung $U_{PE}$ des speichernden Spitzenwertdetektors 27 folgt dieser ansteigenden Spannung, bis der Spitzenwert $U_{E'1}$ erreicht ist. Demzufolge steigt auch der am Triggerpegeleingang 26b des Schwellenwert-Triggers 26 anliegende Triggerpegel $U_{TrE}$ an, wobei dieser Triggerpegel in jedem Zeitpunkt gleich der Hälfte des Augenblickswerts der Spannung des Impulses $E'1$ ist. Es sei daran erinnert, daß dieser Anstieg wegen der Abtastung in Wirklichkeit treppenförmig stattfindet, doch sind die Treppenstufen so fein, daß sie in Fig. 11 nicht dargestellt werden können.

Wenn die Spannung des zeittransformierten Impulses $E'1$ nach dem Erreichen des Spitzenwerts $U_{E'1}$ wieder abzufallen beginnt, bleibt die Triggerpegelspannung $U_{TrE}$ auf dem erreichten Höchstwert $U_{E'1}/2$ stehen. Im Zeitpunkt $-t'_{B1}$ erreicht die den zeittransformierten Impuls $E'1$ darstellende Ausgangsspannung des Verstärkers 25, die am Signaleingang 26a des Schwellenwert-Triggers 26 anliegt, die Höhe des am Triggerpegeleingang 26b des Schwellenwert-Triggers 26 anliegenden Triggerpegels $U_{E'1}/2$. In diesem Zeitpunkt gibt somit der Schwellenwert-Trigger 26 am Ausgang 26c ein Signal ab, das die bistabile Kippschaltung 29 zum Umkippen bringt, so daß ihre Ausgangsspannung am Ausgang 29c vom Wert »0« auf den Wert »1« geht (Diagramm D).

Die gleichen Vorgänge wiederholen sich in identischer Weise in den Schaltungen 21, 22, 23, 24 im Verlauf der Abtastung des zeittransformierten Sendeimpulses $S'1$. Der am Triggerpegeleingang 22b des Schwellenwert-Triggers 22 anliegende Triggerpegel $U_{TrS}$ steigt zusammen mit der Ausgangsspannung des Verstärkers 21 an, bis diese ihren Spitzenwert $U_{S'1}$ erreicht hat; wenn die Ausgangsspannung des Verstärkers 21 anschließend abfällt, bleibt der Triggerpegel auf dem erreichten Höchstwert $U_{S'1}/2$ stehen. Im Zeitpunkt $-t'_{A1}$ besteht wieder Gleichheit zwischen den an den Eingängen 22a und 22b des Schwellenwert-Triggers 22 anliegenden Spannungen, so daß der Schwellenwert-Trigger 22 am Ausgang 22c ein Signal abgibt, das die bistabile Kippschaltung 29 in den Ruhezustand zurücksetzt. Zwischen den Zeitpunkten $-t'_{B1}$ und $-t'_{A1}$ hat die bistabile Kippschaltung somit einen Torimpuls G1 geliefert, der die Torschaltung 30 geöffnet hat. Während der Dauer des Torimpulses G1 hat die Torschaltung 30 die vom Zählimpulsgenerator 31 gelieferten Zählimpulse zum Zähler 32 durchgelassen, so daß der Zähler 32 einen Zählerstand erreicht hat, der der Dauer des Torimpulses G1 proportional ist. Dieser Zählerstand kann in der Anzeigevorrichtung 33 zur Anzeige des Zeitabstands zwischen den Zeitpunkten $-t'_{B1}$ und $-t'_{A1}$ angezeigt werden. Dieser Zeitabstand stellt die gesuchte Meßzeit $T'_{M1}$ im zeittransformierten Bereich dar.

Am Ende der Abtastung des zeittransformierten Sendeimpulses $S'1$ wird ein neuer Meßzyklus durch einen Rückstellimpuls R eingeleitet. Dadurch werden die Triggerpegelspannungen $U_{TrE}$ und $U_{TrS}$ der Schwellenwert-Trigger 26 bzw. 22 wieder auf Null gebracht.

Im Verlauf des neuen Abtastzyklus wiederholen sich dann die zuvor beschriebenen Vorgänge, wobei die am Schwellenwert-Trigger 26 anliegende Triggerpegelspannung einen Wert $U_{E'2}/2$ annimmt, der genau der Hälfte des Spitzenwertes $U_{E'2}$ des zeittransformierten Empfangsimpulses E'2 entspricht, und die am Schwellenwert-Trigger 22 anliegende Triggerpegelspannung einen Wert $U_{S'2}/2$ annimmt, der genau gleich der Hälfte des Spitzenwertes $U_{S'2}$ des zeittransformierten Impulses S'2 ist. Der Zeitpunkt $-t'_{B2}$ des Beginns des Torimpulses G2 liegt somit wieder genau auf der halben Höhe der Rückflanke des zeittransformierten Empfangsimpulses E'2, und der Zeitpunkt $-t'_{A2}$ der Beendigung des Torimpulses G2 liegt genau auf der halben Höhe der Rückflanke des zeittransformierten Sendeimpulses S'2. Die Dauer des Torimpulses G2 stellt die Meßzeit $T'_{M2}$ im zweiten Abtastzyklus dar.

Fig. 11 läßt erkennen, daß die Zeitpunkte $-t'_{B1}$ und $-t'_{B2}$ des Beginns der Zeitmessung stets genau auf der halben Höhe der Rückflanke des betreffenden zeittransformierten Empfangsimpulses E' liegen, auch wenn diese Impulse unterschiedliche Amplituden haben, weil der die Auslösung bestimmende Triggerpegel durch den Spitzenwert des gleichen Impulses bestimmt ist und unabhängig von der Amplitude des vorhergehenden Impulses ist.

Das gleiche gilt für die Beendigung der Meßzeit in den Zeitpunkten $-t'_{A1}$, $-t'_{A2}$, die stets genau mit der halben Höhe der Rückflanken der zeittransformierten Sendeimpulse S' zusammenfällt. Obwohl bei den Sendeimpulsen, im Gegensatz zu den Empfangsimpulsen, angenommen werden kann, daß sich ihre Spitzenwerte und damit die richtigen Triggerpegel im Verlauf der Zeit nicht wesentlich ändern, ist es doch vorteilhaft, die Sendeimpulse in der gleichen Weise zu behandeln wie die Empfangsimpulse. Einerseits entfällt dadurch die Notwendigkeit einer Eichung der Anordnung bei der Inbetriebnahme, und andererseits sind vorübergehende Schwankungen oder Langzeitänderungen im Sendeimpulskanal ohne Einfluß auf die Meßgenauigkeit.

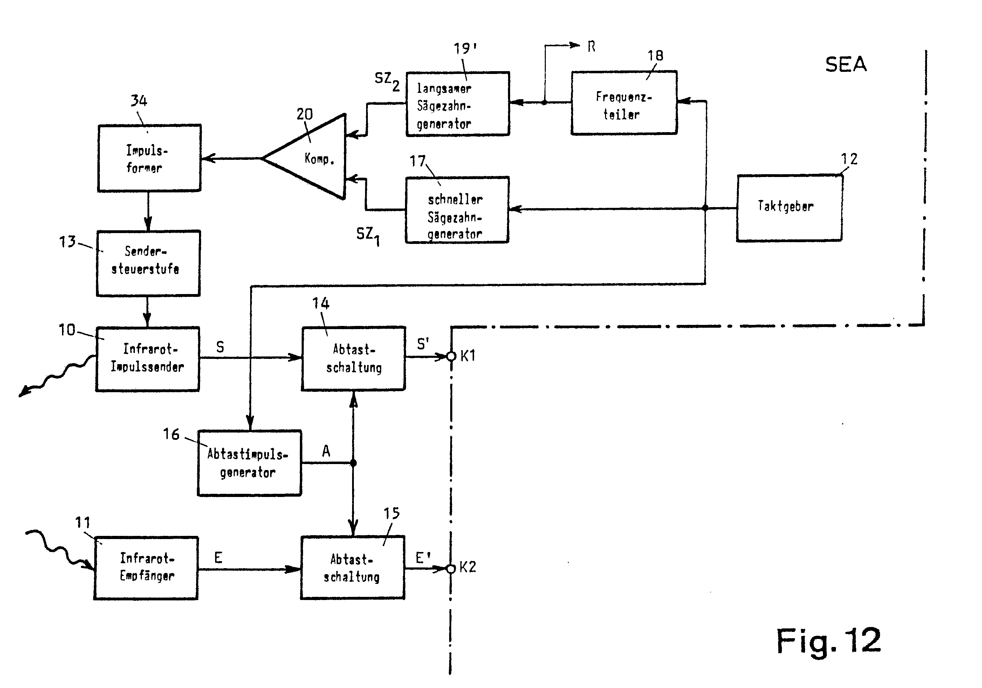

Fig. 12 zeigt eine abgeänderte Ausführungsform der Sende-, Empfangs- und Abtastanordnung SEA, welche die anhand von Fig. 8 erläuterte Erzeugung von Abtastimpulsen A ergibt, deren Periode $T_A$ um die Zeitdifferenz $\Delta t$ kleiner als die Folgefrequenz $T_S$ der abzutastenden Signale ist. Diese Anordnung enthält im wesentlichen die gleichen Bestandteile wie die Teilanordnung SEA von Fig. 10, die mit den gleichen Bezugzeichen wie dort bezeichnet sind. Gegenüber der Anordnung von Fig. 10 bestehen lediglich die folgenden Unterschiede:

— Die vom Taktgeber 12 erzeugten Taktimpulse werden nicht der Sendesteuerstufe 13, sondern dem Abtastimpulsgenerator 16 zugeführt;

— der langsame Sägezahngenerator 19' ist so ausgebildet, daß die schräge Flanke des langsamen Sägezahnsignals $SZ_2$ im gleichen Sinne ansteigt wie die schräge Flanke des schnellen Sägezahnsignals $SZ_1$;

— der Ausgang des Komparators 20 steuert nicht den Abtastimpulsgenerators 16, sondern die Sendersteuerstufe 13 unter Einfügung eines Impulsformers 34.

Demzufolge haben bei der Ausführungsform von Fig. 12 die Abtastimpulse A die gleiche Periode wie die vom Taktgeber 12 abgegebenen Taktimpulse und wie das schnelle Sägezahnsignal $SZ_1$, während die Infrarot-Lichtimpulse und die Sendeimpulse S in Zeitpunkten erzeugt werden, die durch die Feststellung der Koinzidenz zwischen den beiden Sägezahnsignalen $SZ_1$ und $SZ_2$ im Komparator 20 gegeben sind.

Es ist unmittelbar zu erkennen, daß diese Funktionsweise genau der Darstellung in den Diagrammen von Fig. 8 entspricht.

Auf die Bildung der zeittransformierten Sende- und Empfangsimpulse S', E' hat diese Abänderung keinen Einfluß, denn hierfür kommt es nur darauf an, daß die Folgeperiode $T_A$ der Abtastimpulse A um die Zeitdifferenz $\Delta t$ kleiner als die Folgeperiode $T_S$ der Sendeimpulse S ist.

Die Messung des zeittransformierten Zeitabstands $T'_M$ zwischen den zeittransformierten Empfangsimpulsen E' und den zeittransformierten Sendeimpulsen S', die mit der Anordnung von Fig. 12 erhalten werden, kann also in gleicher Weise wie bei der Anordnung von Fig. 10 erfolgen, beispielsweise mit Hilfe der dort dargestellten Zeitmeßanordnung $Z_M$, wenn diese an die Klemmen K1, K2 in Fig. 12 angeschlossen ist.

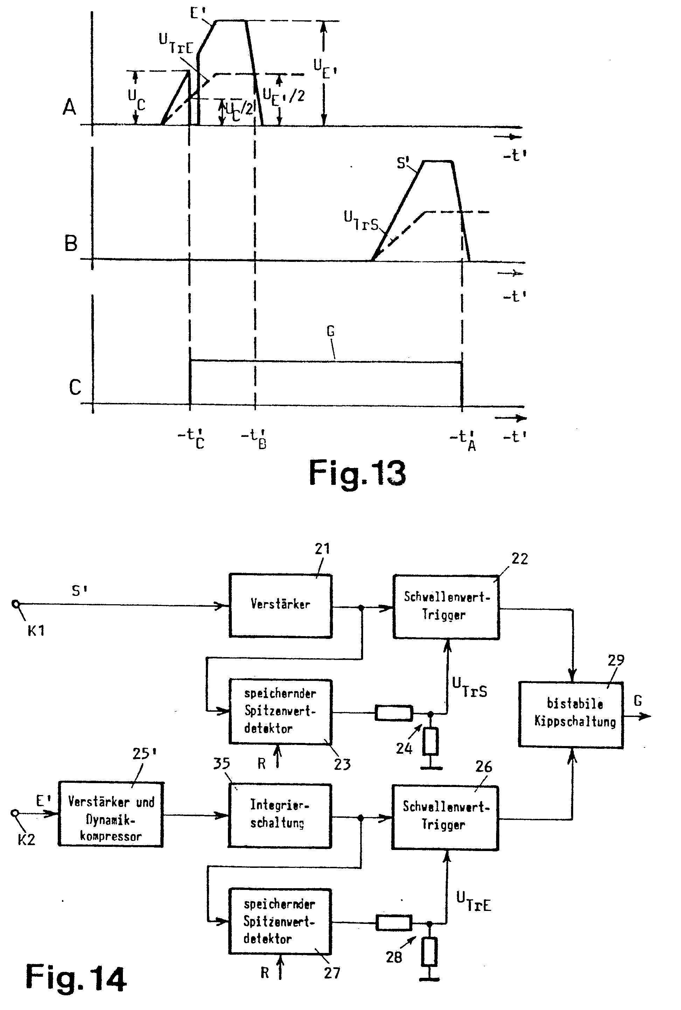

Bei den bisher beschriebenen Anordnungen besteht die Möglichkeit von Meßfehlern, wenn in dem Zeitintervall innerhalb des Abtastzyklus, in welchem die Empfangsimpulse abgetastet werden, Echtzeit-Empfangsimpulse E ausfallen oder mit stark verringerter Amplitude empfangen werden. Dies soll anhand von Fig. 13 erläutert werden.

Fig. 13 zeigt im zeittransformierten Bereich $-t'$ den Verlauf eines Abtastzyklus ähnlich der Darstellung von Fig. 11. Das Diagramm A von Fig. 13 zeigt einen zeittransformierten Empfangsimpuls E', das Diagramm B einen zeittransformierten Sendeimpuls S' und das Diagramm C den am Ausgang der bistabilen Kippschaltung 29 erhaltenen Torimpuls G. Ferner sind in den Diagrammen A und B von Fig. 13 die Triggerpegelspannungen $U_{TrE}$ und $U_{TrS}$, in gleicher Weise wie in Fig. 11, durch gestrichelte Kurven dargestellt.

Wenn der zeittransformierte Empfangsimpuls E' vollständig und lückenlos durch Abtastung erhalten wird, bestehen die gleichen Verhältnisse wie in Fig. 11, so daß der Beginn des Torimpulses G im Zeitpunkt −t′$_B$ ausgelöst wird, der der halben Höhe der Rückflanke des zeittransformierten Empfangsimpulses E′ entspricht.

Im Diagramm A von Fig. 13 ist jedoch angenommen, daß in einem Zeitpunkt −t′$_C$, in welchem die Spannung des zeittransformierten Empfangsimpulses E′ den Wert U$_C$ erreicht hat, mehrere Echtzeit-Empfangsimpulse vollständig ausfallen, so daß in diesen Echtzeit-Perioden die Spannung Null abgetastet wird. Dadurch ergibt sich in dem zeittransformierten Empfangsimpuls E′ ein vorübergehender Einbruch, der anschließend wieder verschwindet, wenn die folgenden Echtzeit-Empfangsimpulse wieder mit voller Amplitude empfangen werden. Am Beginn des Einbruchs im Zeitpunkt −t′$_C$ fällt aber die Signalspannung am Eingang 26a des Schwellenwert-Triggers 26 (Fig. 10) unter den bis dahin erreichten Triggerpegel U$_C$/2, was zur Folge hat, daß der Schwellenwert-Trigger 26 im Zeitpunkt −t′$_C$ ein Signal zum Setzeingang der bistabilen Kippschaltung 29 liefert, so daß der Torimpuls G bereits im Zeitpunkt −t′$_C$ anstatt im Zeitpunkt −t′$_B$ beginnt. Auf diese Weise wird offensichtlich eine zu große Meßzeit T′$_M$ gemessen. Der anschließende Wiederanstieg der Spannung des zeittransformierten Empfangsimpulses E′ und der erneute Durchgang durch den Triggerpegel im Zeitpunkt −t′$_B$ hat keinen Einfluß auf die Dauer des Torimpulses G.

Es ist offensichtlich, daß der anhand von Fig. 13 erläuterte Meßfehler nicht nur dann auftritt, wenn die Echtzeit-Empfangsimpulse vorübergehend vollständig ausfallen, sondern auch bereits dann, wenn Echtzeit-Empfangsimpulse mit einer Amplitude empfangen werden, die kleiner als der bis dahin erreichte Triggerpegel ist.

Fig. 14 zeigt eine abgeänderte Ausführungsform eines Teils der Zeitmeßschaltung ZM von Fig. 10, mit welcher die Gefahr des Auftretens der anhand von Fig. 13 erläuterten Meßfehler vermieden wird.

Die sich an den Ausgang der bistabilen Kippschaltung 29 anschließenden Schaltungsteile 30, 31, 32, 33 sind in Fig. 14 zur Vereinfachung fortgelassen; sie können die gleiche Ausbildung wie in Fig. 10 haben.

Der in Fig. 14 gezeigte Teil der Zeitmeßanordnung ZM unterscheidet sich von der Ausführungsform von Fig. 10 nur in folgender Hinsicht:

— Der an die Klemme K2 angeschlossene Eingangsverstärker 25′ ist gleichzeitig als Dynamikkompressor ausgeführt, dessen Verstärkung in Abhängigkeit von dem Momentanwert der Eingangsspannung so nachgestellt wird, daß der Verstärkungsfaktor mit zunehmender Eingangsspannung kleiner wird, aber bei abnehmender Eingangsspannung konstant bleibt;

— dem Ausgang des Verstärkers und Dynamikkompressors 25′ ist eine Integrierschaltung 35 nachgeschaltet, die einen Abfall der Ausgangsspannung des Verstärkers und Dynamikkompressors 25′ nur mit einer vorgegebenen Zeitkonstante erlaubt.

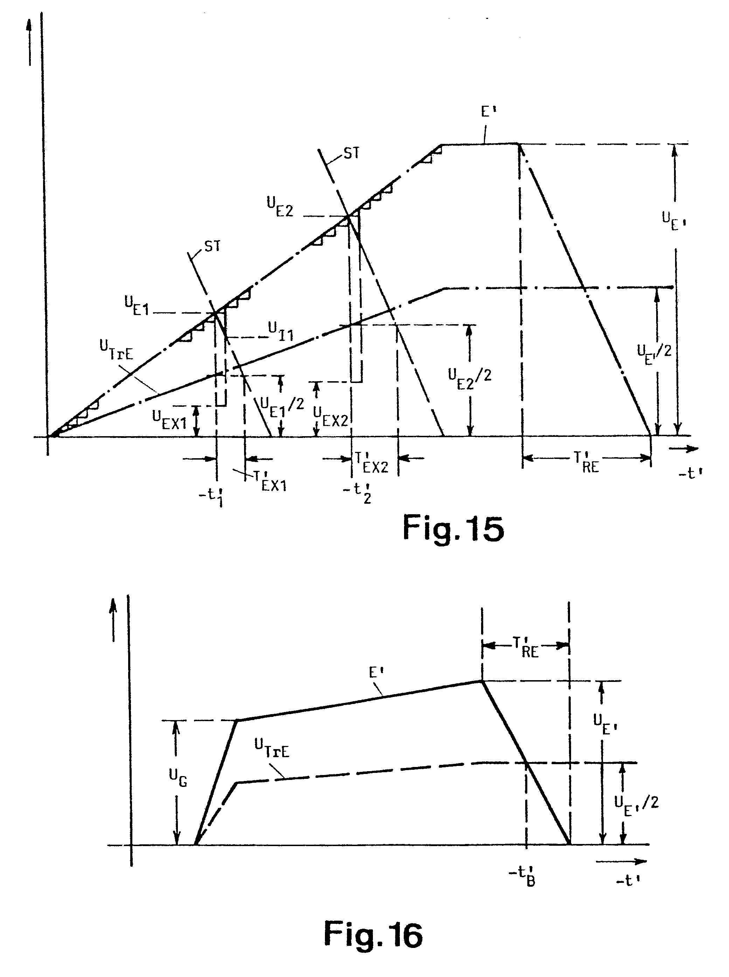

Die mit diesen Abänderungen erzielte Wirkung soll anhand der Figuren 15, und 16 erläutert werden.

Fig. 15 zeigt in stark vereinfachter Darstellung einen zeittransformierten Empfangsimpuls E′, an dessen ansteigender Vorderflanke (die den Rückflanken der Echtzeit-Empfangsimpulse E entspricht) die Treppenkurve angedeutet ist, die sich aus den aus aufeinanderfolgenden Echtzeit-Empfangsimpulsen entnommenen Abtastwerten ergibt. Die Rückflanke des Empfangsimpulses E′, die in Wirklichkeit ebenfalls durch eine solche Treppenkurve gebildet ist, hat eine Abfallzeit, die der zeittransformierten Anstiegszeit T′$_{RE}$ der Empfangsimpulse entspricht.

Ferner ist in Fig. 15 die am Eingang 26b des Schwellenwert-Triggers 26 anliegende Triggerpegelspannung U$_{TrE}$ durch eine strichpunktierte Linie dargestellt.

Die Zeitkonstante der Integrierschaltung 35 wird vorzugsweise so eingestellt, daß die negative Steigung des Abfalls der Ausgangsspannung des Verstärkers 25′ etwa gleich der negativen Steigung der Rückflanke des zeittransformierten Empfangsimpulses E′ gemacht wird.

In Fig. 15 ist angenommen, daß in einem Zeitpunkt −t′$_1$, in welchem die ansteigende Flanke des zeittransformierten Empfangsimpulses E′ bereits den Spannungswert U$_{E1}$ erreicht hat, ein Echtzeit-Empfangsimpuls mit sehr stark verringerter Amplitude einfällt, so daß aus diesem Echtzeit-Empfangsimpuls ein Abtastwert U$_{EX1}$ entnommen wird, der wesentlich kleiner als der im Zeitpunkt −t′$_1$ erreichte Triggerpegel U$_{E1}$/2 ist. Die Ausgangsspannung des Verstärkers 25′ von Fig. 14 fällt daher plötzlich vom Wert U$_{E1}$ auf den Wert U$_{EX1}$ ab. Dagegen kann die Ausgangsspannung der Integrierschaltung 35 infolge der eingestellten Zeitkonstante nur mit einer negativen Steigung abfallen, die durch die Gerade ST bestimmt ist, die etwa parallel zu der Rückflanke des zeittransformierten Empfangsimpulses E′ verläuft. Wenn der nächste Empfangsimpuls wieder mit voller Amplitude einfällt, ist die Ausgangsspannung der Integrierschaltung 35 vorübergehend nur auf einen Wert U$_{I1}$ abgefallen, der noch wesentlich über dem im betreffenden Zeitpunkt bestehenden Triggerpegel U$_{E1}$/2 liegt, so daß keine Auslösung der bistabilen Kippschaltung 29 erfolgt.

Fig. 15 läßt erkennen, daß auch beim Ausfall oder verminderten Einfall mehrerer aufeinanderfolgender Empfangsimpulse noch keine Unterschreitung des Triggerpegels U$_{E1}$/2 und somit keine fehlerhafte Auslösung der Messung stattfinden würde. Die nach der Geraden ST abfallende Ausgangsspannung der Integrierschaltung 35 erreicht den Triggerpegel U$_{E1}$/2 erst nach einer Ausfallzeit T′$_{EX1}$, die durch folgende Formel gegeben ist:

$$T'_{EX1} = \frac{T'_{RE}}{2} \cdot \frac{U_{E1}}{U_{E'}}$$

wenn $U_{E'}$, wie in Fig. 15 dargestellt, die Spitzenamplitude des zeittransformierten Eingangsimpulses E' ist.

Wenn ein zweiter Ausfall von Impulsen in einem Zeitpunkt $-t'_2$ beginnt, bei welchem die ansteigende Flanke des zeittransformierten Empfangsimpulses E' den Spannungswert $U_{E2}$ erreicht hat, so daß sich der Triggerpegel auf den Wert $U_{E2}/2$ eingestellt hat, ergibt sich eine zulässige Ausfallzeit $T'_{EX2}$, die größer als die zulässige Ausfallzeit $T'_{EX1}$ ist, die im Zeitpunkt $-t'_1$ beginnt. Daraus ist zu erkennen, daß die zulässige Ausfallzeit $T'_{EX}$ um so kleiner ist, je kleiner die bis zum Ausfallzeitpunkt erreichte Spannung des zeittransformierten Empfangsimpulses E' ist. Somit sind insbesondere am Beginn der Abtastung der Empfangsimpulse die zulässigen Ausfallzeiten gering.

Um auch in diesem Anfangsbereich den Einfluß ausbleibender oder stark geschwächter Echoimpulse zu verringern, ist der Eingangsverstärker 25' als Dynamikkompressor ausgebildet, dessen Verstärkungsfaktor jedoch nicht, wie bei üblichen Dynamikkompressoren, dem Pegel des Eingangssignals in aufsteigender und absteigender Richtung nachgeregelt wird, sondern mit zunehmendem Pegel des Eingangssignals verringert wird, aber bei abnehmendem Pegel des Eingangssignals den zuletzt erreichten Wert beibehält, so daß der Verstärkungsfaktor bei der abfallenden Flanke der verstärkten Impulse nicht mehr verändert wird.

Die damit erzielte Wirkung wird anhand von Fig. 16 erläutert. Das Diagramm von Fig. 16 zeigt das Ausgangssignal des als Dynamikkompressor ausgebildeten Verstärkers 25', wenn vereinfacht angenommen wird, daß der Verstärkungsfaktor zwischen zwei Werten umgeschaltet wird. Bis zum Erreichen eines Spannungswertes $U_G$ hat der Verstärker 25' einen großen Verstärkungsfaktor, so daß die Flanke des zeittransformierten Empfangsimpulses E' steil ansteigt. Beim Erreichen der Spannung $U_G$ wird der Verstärkungsfaktor auf einen kleineren Wert umgeschaltet, so daß nunmehr der Anstieg langsamer erfolgt. Die Triggerpegelspannung $U_{TrE}$ folgt dem Verlauf der ansteigenden Flanke im gleichbleibenden Verhältnis 1 : 2. Da während der abfallenden Rückflanke des zeittransformierten Empfangsimpulses E' der Verstärkungsfaktor konstant bleibt, erfolgt die Auslösung der Zeitmessung wieder im richtigen Zeitpunkt auf der halben Höhe der Rückflanke. Die Zeitmessung wird somit durch die Dynamikkompression nicht beeinträchtigt. Dagegen ist zu erkennen, daß im Anfangsbereich des zeittransformierten Empfangsimpulses E' sehr schnell verhältnismäßig große Spannungen erreicht werden, was entsprechend große zulässige Ausfallzeiten $T'_{EX}$ zur Folge hat, wie anhand von Fig. 15 erläutert worden ist.

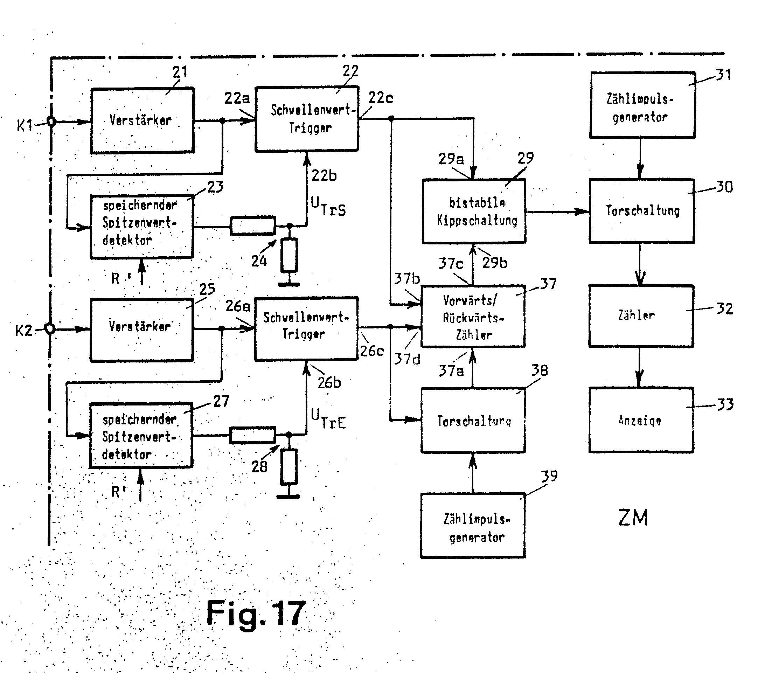

Fig. 17 zeigt eine abgeänderte Ausführungsform der Zeitmeßanordnung ZM von Fig. 10, mit der Rereflexionen unterdrückt werden, wie sie bei Meßverfahren, die auf dem Echoprinzip beruhen, unvermeidlich auftreten. Solche Rereflexionen erscheinen infolge der Zeitinvertierung im zeittransformierten Signal vor dem für die Messung gültigen Empfangsimpuls, der im Echtzeitsignal der erste Empfangsimpuls und somit im invertierten zeittransformierten Signal der letzte Empfangsimpuls ist.

Die in Fig. 17 mit den gleichen Bezugszeichen wie in Fig. 10 bezeichneten Schaltungsteile haben den gleichen Aufbau und die gleiche Funktion, weshalb sie hier nicht nochmals beschrieben werden.

Gegenüber der Ausführungsform von Fig. 10 bestehen jedoch die folgenden Unterschiede: Der Setzeingang 29a der bistabilen Kippschaltung 29 ist an den Ausgang 22c des Schwellenwert-Triggers 22 angeschlossen. Das Rücksetzen der bistabilen Kippschaltung 29 erfolgt durch einen Vorwärts/Rückwärts-Zähler 37, der an seinem Zählimpulseingang 37a die von einem Zählimpulsgenerator 39 gelieferten Impulse über eine Torschaltung 38 empfängt. Der Vorwärts/Rückwärts-Zähler hat einen Steuereingang 37b, der mit dem Ausgang 22c des Schwellenwert-Triggers 22 verbunden ist und zur Umschaltung zwischen Vorwärtszählung und Rückwärtszählung dient. Der Vorwärts/Rückwärts-Zähler 37 zählt vorwärts, wenn das am Steuereingang 37b anliegende Signal den Wert »0« hat, während er rückwärts zählt, wenn dieses Signal den Wert »1« hat. Der Vorwärts/Rückwärts-Zähler 37 liefert an einem Ausgang 37c einen Impuls, wenn er bei der Rückwärtszählung den Zählerstand Null erreicht; dieser Ausgang 37c ist mit dem Rücksetzeingang 29b der bistabilen Kippschaltung 29 verbunden. Schließlich hat der Vorwärts/Rückwärts-Zähler 37 einen Rücksetzeingang 37d, der an den Ausgang 26c des Schwellenwert-Triggers 26 angeschlossen ist. Der Zählerstand des Vorwärts/Rückwärts-Zählers 37 wird auf den Wert Null zurückgestellt, wenn das dem Rücksetzeingang 37d zugeführte Signal von »1« auf »0« geht. Schließlich ist der Steuereingang der Torschaltung 38 ebenfalls an den Ausgang 26c des Schwellenwert-Triggers 26 angeschlossen.

Es ist zu erkennen, daß die Schaltungsteile 37, 38, 39 eine Zeitmeßanordnung von gleicher Art wie die Schaltungsteile 30, 31, 32 bilden.

Wie später noch erläutert wird, haben die den Rückstelleingängen der speichernden Spitzenwertdetektoren 23 und 27 zugeführten Rückstellimpulse R' eine andere zeitliche Lage als die Rückstellimpulse R in Fig. 10 und 11; außerdem ist zumindest der Spitzenwertdetektor 27 so ausgebildet, daß die gespeicherte Spannung durch den Rückstellimpuls R' nicht auf Null, sondern auf einen von Null verschiedenen Anfangswert zurückgestellt wird.

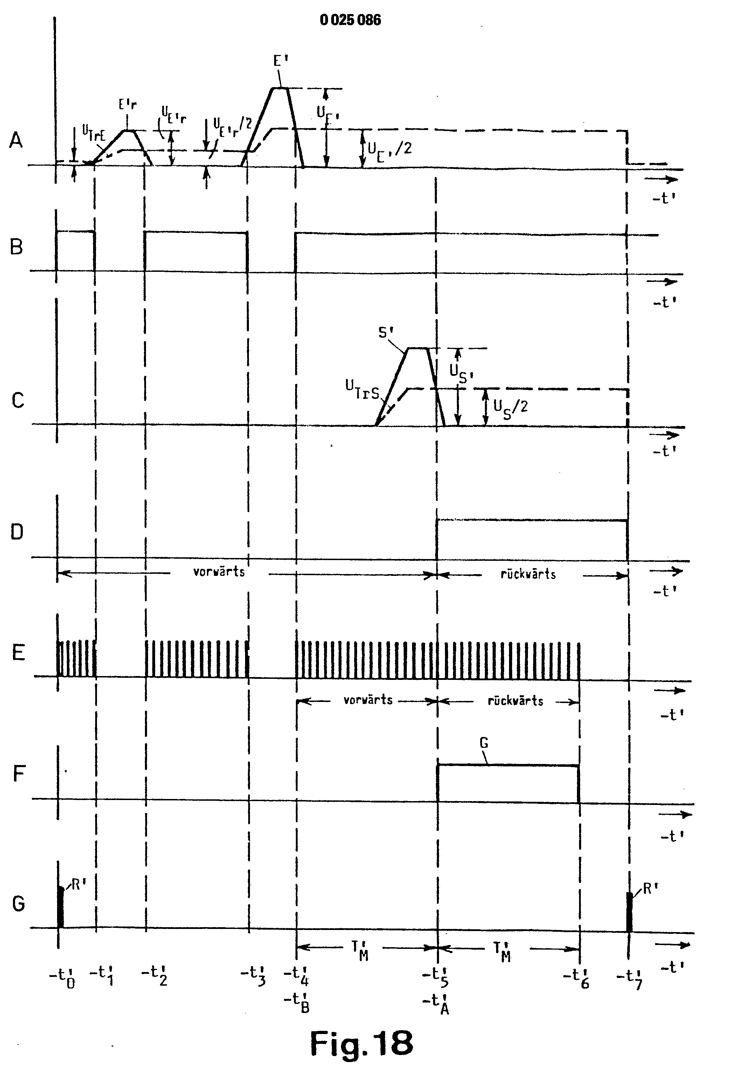

Die Funktionsweise der Anordnung von Fig. 17 soll anhand der Diagramme von Fig. 18 erläutert werden.

Die Diagramme von Fig. 18 zeigen verschiedene Signale, die in der Zeitmeßanordnung von Fig. 17 im Verlauf eines Abtastzyklus auftreten. Alle Diagramme sind im invertierten zeittransformierten Bereich $-t'$ dargestellt.

Das Diagramm A zeigt die am Ausgang des Verstärkers 25 erscheinenden zeittransformierten Empfangsimpulse $E'$, die am Signaleingang 26a des Schwellenwert-Triggers 26 anliegen, sowie in einer gestrichelten Linie den am Triggerpegeleingang 26b des Schwellenwert-Triggers 26 anliegenden Triggerpegel $U_{TrE}$. Außer dem Empfangsimpuls $E'$, der der ersten Reflexion entspricht und für die Zeitmessung gültig ist, ist der der ersten Rereflexion entsprechende Empfangsimpuls $E'r$ dargestellt. Da die den Rereflexionen entsprechenden Empfangsimpulse im Echtzeitbereich nach dem ersten Echoimpuls eintreffen, erscheinen die entsprechenden zeittransformierten Empfangsimpulse im invertierten zeittransformierten Bereich vor dem zu detektierenden Empfangsimpuls $E'$. Den tatsächlichen Verhältnissen entsprechend ist ferner angenommen, daß der Empfangsimpuls $E'r$ eine wesentlich kleinere Amplitude als der Empfangsimpuls $E'$ hat. Es können noch weitere zeittransformierte Empfangsimpulse vorhanden sein, die Rereflexionen höherer Ordnung entsprechen, sie würden noch vor dem dargestellten Empfangsimpuls $E'r$ liegen und noch kleinere Amplituden haben.

Das Diagramm B zeigt die Spannung am Ausgang 26c des Schwellenwert-Triggers 26.

Das Diagramm C zeigt den am Ausgang des Verstärkers 21 erscheinenden zeittransformierten Sendeimpuls $S'$, der am Signaleingang 22a des Schwellenwert-Triggers 22 anliegt, sowie in einer gestrichelten Linie den Triggerpegel $U_{TrS}$, der am Triggerpegeleingang 22b des Schwellenwert-Triggers 22 anliegt. Das Diagramm D zeigt die Ausgangsspannung am Ausgang 22c des Schwellenwert-Triggers 22.

Im Diagramm E sind die von der Torschaltung 38 zum Zählimpulseingang 37a des Vorwärts/Rückwärts-Zählers 37 durchgelassenen Zählimpulse gezeigt.

Das Diagramm F stellt den am Ausgang 29c der bistabilen Kippschaltung 29 erscheinenden Torimpuls G dar.

Schließlich sind im Diagramm G die Rückstellimpulse $R'$ gezeigt, die jeweils den Beginn eines neuen Meßzyklus einleiten.

Am Beginn des dargestellten Meßzyklus im Zeitpunkt $-t'_0$ werden die in den Spitzenwertdetektoren 23 und 27 gespeicherten Spitzenwerte und demzufolge auch die Triggerpegel $U_{TrE}$ und $U_{TrS}$ durch den Rückstellimpuls $R'$ auf den Anfangswert zurückgestellt. Das Ausgangssignal des Schwellenwert-Triggers 26 wird auf den Wert »1« gebracht (Diagramm B), wodurch die Torschaltung 38 für die Übertragung von Zählimpulsen zum Vorwärts/Rückwärts-Zähler 37 geöffnet wird (Diagramm E). Das Ausgangssignal des Schwellenwert-Triggers 22 (Diagramm D) wird auf den Wert »0« gebracht, so daß der Vorwärts/Rückwärts-Zähler 37 auf Vorwärtszählung eingestellt ist. Somit werden die über die Torschaltung 38 übertragenen Zählimpulse im Vorwärts/Rückwärts-Zähler 37 in der Vorwärtsrichtung gezählt.

Im Zeitpunkt $-t'_1$ überschreitet die ansteigende Flanke des Empfangsimpulses $E'r$ den eingestellten Triggerpegel $U_{TrE}$. Dies hat zur Folge, daß das Ausgangssignal des Schwellenwert-Triggers 26 auf »0« geht. Dadurch wird die Torschaltung 38 gesperrt und gleichzeitig der Vorwärts/Rückwärts-Zähler 37 auf Null zurückgestellt. Die Spannung des Empfangsimpulses $E'r$ steigt auf den Spitzenwert $U_{E'r}$ an, und damit gleichlaufend geht der Triggerpegel $U_{TrE}$ auf den Wert $U_{E'r}/2$.

Im Zeitpunkt $-t'_2$ besteht Koinzidenz zwischen der abfallenden Flanke des Empfangsimpulses $E'r$ und dem Triggerpegel $U_{E'r}/2$. Dies hat zur Folge, daß die Ausgangsspannung des Schwellenwert-Triggers 26 wieder auf »1« geht, so daß die Torschaltung 38 erneut geöffnet wird. Die übertragenen Zählimpulse werden im Vorwärts/Rückwärts-Zähler 37 erneut in der Vorwärtsrichtung gezählt. Der zuletzt erreichte Triggerpegel des Wertes $U_{E'r}/2$ bleibt am Eingang 26b des Schwellenwert-Triggers 26 bestehen.

Im Zeitpunkt $-t'_3$ erreicht die ansteigende Flanke des Empfangsimpulses $E'$ den zuletzt eingestellten Triggerpegel, so daß die Ausgangsspannung des Schwellenwert-Triggers 26 erneut auf »0« geht, die Torschaltung 38 gesperrt wird und der Vorwärts/Rückwärts-Zähler 37 auf Null zurückgestellt wird.

Anschließend steigt die Spannung des Empfangsimpulses $E'$ auf den Spitzenwert $U_{E'}$ an, und gleichlaufend damit geht der Triggerpegel $U_{TrE}$ auf den Wert $U_{E'}/2$.

Wenn im Zeitpunkt $-t'_4$ die Koinzidenz zwischen der abfallenden Flanke des Empfangsimpulses $E'$ und dem erreichten Triggerpegel $U_{E'}/2$ besteht, geht die Ausgangsspannung des Schwellenwert-Triggers 26 wieder auf »1«. Die Torschaltung 38 wird erneut geöffnet, und der Vorwärts/Rückwärts-Zähler 37 beginnt wieder die Zählung der Zählimpulse vom Zählerstand Null an in der Vorwärtsrichtung.

Da der Empfangsimpuls $E'$ der für die Zeitmessung gültige Empfangsimpuls ist, entspricht der Zeitpunkt $-t'_4$ zugleich dem Zeitpunkt $-t'_B$ des Beginns der eigentlichen zeittransformierten Meßzeit $T'_M$. Diese Meßzeit endet im Zeitpunkt $-t'_5$, in welchem die abfallende Flanke des Sendeimpulses $S'$ in Koinzidenz mit dem Triggerpegel $U_{TrS}$ ist, der in diesem Zeitpunkt den Wert $U_{S'}/2$ erreicht hat, der gleich dem halben Spitzenwert $U'_{S'}$ des zeittransformierten Sendeimpulses $S'$ ist. Somit entspricht der Zeitpunkt $-t'_5$ dem Endzeitpunkt $-t'_A$ der eigentlichen zeittransformierten Meßzeit $T'_M$.

Im Zeitpunkt $-t'_5$ geht die Ausgangsspannung am Ausgang 22c des Schwellenwert-Triggers 22 (Diagramm D) auf »1«, wodurch der Vorwärts/Rückwärts-Zähler 37 auf Rückwärtszählung umgeschaltet wird. Gleichzeitig bringt die am Eingang 29a der bistabilen Kippschaltung 29 erscheinende ansteigende Impulsflanke die bistabile Kippschaltung zum Umkippen, so daß das Ausgangssignal am Ausgang 29c auf »1« geht. Dies entspricht dem Beginn des Torimpulses G (Diagramm F).

Da das Ausgangssignal des Schwellenwert-Triggers 26 den Wert »1« behält, bleibt die Torschaltung geöffnet, so daß dem Zählimpulseingang 37a des Vorwärts/Rückwärts-Zählers 37 weiterhin Zählimpulse zugeführt werden, die aber nunmehr in der Rückwärtsrichtung gezählt werden. Der Zählerstand des Vorwärts/Rückwärts-Zählers 37 verringert sich, bis im Zeitpunkt $-t'_6$ der Zählerstand Null erreicht wird. In diesem Zeitpunkt erscheint am Ausgang 37c ein Signal, das dem Rücksetzeingang 29b der bistabilen Kippschaltung 29 zugeführt wird und die bistabile Kippschaltung in den Ausgangszustand zurückstellt. Dadurch wird der Torimpuls G am Ausgang 29c beendet.

Es ist unmittelbar zu erkennen, daß die Anzahl der zwischen den Zeitpunkten $-t'_5$ und $-t'_6$ gezählten Zählimpulse genau gleich der Anzahl der zwischen den Zeitpunkten $-t'_4$ und $-t'_5$ in der Vorwärtsrichtung gezählten Zählimpulse ist. Der Zeitabstand zwischen den Zeitpunkten $-t'_5$ und $-t'_6$ ist somit genau gleich dem Zeitabstand zwischen den Zeitpunkten $-t'_4$ und $-t'_5$, also genau gleich der zeittransformierten Meßzeit $T'_M$. Die Dauer des Torimpulses G ist daher auch in diesem Fall gleich der gesuchten Meßzeit $T'_M$, die durch die Schaltungen 30, 31, 32, 33 in der zuvor erläuterten Weise gemessen und zur Anzeige gebracht wird.

Im Zeitpunkt $-t'_7$ erscheint ein neuer Rückstellimpuls R', der den nächsten Meßzyklus einleitet. Es ist jedoch zu beachten, daß, im Gegensatz zu der anhand von Fig. 11 erläuterten Funktionsweise, dieser Rückstellimpuls R' nicht unmittelbar mit dem Ende des zeittransformierten Sendeimpulses S' zusammenfallen darf, sondern erst in einem Zeitabstand erscheinen darf, der mindestens gleich der größten vorkommenden zeittransformierten Meßzeit $T'_M$ ist.

Wie die vorstehende Beschreibung erkennen läßt, ergibt die Schaltung von Fig. 17 die Wirkung, daß nur der letzte zeittransformierte Empfangsimpuls E', der vor dem zeittransformierten Sendeimpuls S' erscheint, für die Zeitmessung ausgenutzt wird, während die durch jeden früheren, auf Rereflexion beruhenden Empfangsimpuls E'r eingeleitete Zeitmessung jeweils durch den nächsten eintreffenden zeittransformierten Empfangsimpuls wieder gelöscht wird. Auf diese Weise werden die auf Rereflexion beruhenden Empfangsimpulse unterdrückt.

Anstelle der linearen Sägezahnsignale können auch exponentiell ansteigende Sägezahnsignale oder anstelle eines linearen langsamen Sägezahnsignals ein treppenförmig ansteigendes Sägezahnsignal verwendet werden.

Auch ist es bei der Anordnung von Fig. 10 möglich, für die Abtastung der Sendeimpulse und der Empfangsimpulse die gleiche Abtastschaltung zu verwenden, so daß die Zeitmeßanordnung nur einen Schwellenwert-Trigger und nur einen speichernden Spitzenwertdetektor enthält; in diesem Fall braucht nur dafür gesorgt zu werden, daß die Zeitmessung in jedem Meßzyklus jeweils durch das erste Ausgangssignal des Schwellenwert-Triggers in Gang gesetzt und durch das zweite Ausgangssignal stillgesetzt wird. Das beschriebene Verfahren eignet sich besonders gut für diese Vereinfachung, weil der Triggerpegel für jeden Impuls neu eingestellt wird. Schließlich kann die Zeitmessung auch auf irgendeine andere geeignete Weise anstatt durch Impulszählung erfolgen.

## Patentansprüche

1. Verfahren zur Impulsabstandsmessung bei periodischen Impulspaaren (S, E), insbesondere bei der Impuls-Rückstrahlortung, durch Messung des Zeitabstands ($T_M$) zwischen den Zeitpunkten der Koinzidenz einer Impulsflanke mit einem Triggerpegel ($U_{Tr}$), der in einem vorgegebenen Verhältnis zum Spitzenwert ($U_S$, $U_E$) der Impulse eingestellt wird, dadurch gekennzeichnet, daß die Impulspaare nach dem Sampling-Verfahren mit Hilfe von Abtastimpulsen (A) abgetastet werden, deren Folgeperiode ($T_A$) um eine vorgegebene kleine Zeitdifferenz ($\Delta t$) kleiner als die Folgeperiode ($T_S$) der Impulspaare ist, daß für jeden durch die Abtastung erhaltenen zeittransformierten Impuls (S', E') der Spitzenwert ($U_{S'}$, $U_{E'}$) festgestellt und der im vorgegebenen Verhältnis zum Spitzenwert stehende Triggerpegel ($U_{TrS}$, $U_{TrE}$) eingestellt wird, und daß die Messung des Zeitabstands ($T_{M'}$) zwischen den Zeitpunkten der Koinzidenz an Hand der Koinzidenz der hinteren Impulsflanke jedes zeittransformierten Impulses mit dem zugehörigen Triggerpegel erfolgt.

2. Verfahren nach Anspruch 1, dadurch gekennzeichnet, daß der Triggerpegel auf die Hälfte des Spitzenwerts eingestellt wird ($U_{S'}/2$, $U_{E'}/2$).

3. Verfahren nach Anspruch 1 oder 2, dadurch gekennzeichnet, daß die Abtastimpulse (A) in den Zeitpunkten der Koinzidenz der ansteigenden Flanken eines schnellen Sägezahnsignals ($SZ_1$), dessen Periode gleich der Folgeperiode ($T_S$) der Impulspaare (S, E) ist, mit der abfallenden Flanke eines sich in entgegengesetztem Sinne ändernden langsamen Sägezahnsignals ($SZ_2$) erzeugt werden (Fig. 9).

4. Verfahren nach Anspruch 1 oder 2, dadurch gekennzeichnet, daß die Folgeperioden der Impulspaare (S, E) durch Synchronisierimpulse ausgelöst werden, die in den Zeitpunkten der Koinzidenz der ansteigenden Flanken eines schnellen Sägezahnsignals ($SZ_1$), dessen Periode gleich der Folgeperiode der Abtastimpulse (A) ist, mit der ansteigenden Flanke eines sich im gleichen Sinne ändernden langsamen Säge-

zahnsignals (SZ$_2$ in Fig. 8) erzeugt werden.

5. Anordnung zur Durchführung des Verfahrens nach einem der vorhergehenden Ansprüche, mit wenigstens einer durch die Abtastimpulse gesteuerten Abtastschaltung, die am Ausgang die zeittransformierten Impulse (S', E') liefert, dadurch gekennzeichnet, daß der Ausgang (14c, 15c) jeder Abtastschaltung (14, 15) mit dem Signaleingang (22a, 26a) eines Schwellenwert-Triggers (22, 26) verbunden ist, der am Ausgang (22c, 26c) ein Signal liefert, wenn die Rückflanke seines Eingangssignals in Koinzidenz mit einem Triggerpegel ($U_{TrS}$, $U_{TrE}$) ist, der an einen Triggerpegeleingang (22b, 26b) angelegt ist, daß der Ausgang (14c, 15c) jeder Abtastschaltung (14, 15) außerdem mit dem Signaleingang (23a, 27a) eines speichernden Spitzenwertdetektors (23, 27) verbunden ist, der am Ausgang (23c, 27c) ein Signal ($U_{PS}$, $U_{PE}$) liefert, das am Beginn jedes Meßzyklus auf einen Anfangswert rückstellbar ist und anschließend dem jeweils seit der letzten Rückstellung erreichten Größtwert seines Eingangssignals entspricht, daß ein in einem vorgegebenen Verhältnis zum Ausgangssignal des Spitzenwertdetektors stehendes Signal ($U_{TrS}$, $U_{TrE}$) an den Triggerpegeleingang (22b, 26b) des Schwellenwert-Triggers (22, 26) angelegt ist, und daß eine Zeitmeßanordnung (30, 31, 32, 33) zur Messung des Zeitabstands ($T'_M$) zwischen dem dem einen zeittransformierten Impuls (E') jedes Impulspaares (E', S') entsprechenden Ausgangssignal eines Schwellenwert-Triggers (26) und dem dem anderen zeittransformierten Impuls (S') jedes Impulspaares (E', S') entsprechenden Ausgangssignal eines Schwellenwert-Triggers (22) vorgesehen ist.

6. Anordnung nach Anspruch 5, dadurch gekennzeichnet, daß für die beiden Impulse (S, E) jedes Impulspaares getrennte Schaltungskanäle mit jeweils einer Abtastschaltung (14, 15), einem Schwellenwert-Trigger (22, 26) und einem speichernden Spitzenwertdetektor (23, 27) vorgesehen sind.

7. Anordnung nach Anspruch 6, dadurch gekennzeichnet, daß das Ausgangssignal des im einen Schaltungskanal enthaltenen Schwellenwert-Triggers (26) die Zeitmeßanordnung (30, 31, 32, 33) in Gang setzt und das Ausgangssignal des im anderen Schaltungskanal enthaltenen Schwellenwert-Triggers (22) die Zeitmeßanordnung stillsetzt.

8. Anordnung nach Anspruch 6 oder 7 bei der Impuls-Rückstrahlortung, dadurch gekennzeichnet, daß die dem ersten Schaltungskanal (14, 22, 23) zugeführten Impulse die Sendeimpulse (S) und die dem zweiten Schaltungskanal (15, 26, 27) zugeführten Impulse die Empfangsimpulse (E) des Impuls-Rückstrahlortungssystems sind.

9. Anordnung nach Anspruch 8, dadurch gekennzeichnet, daß im zweiten Schaltungskanal der Abtastschaltung (15) eine Integrierschaltung (35) nachgeschaltet ist, die den Abfall ihres Ausgangssignals auf eine vorbestimmte negative Steigung begrenzt.

10. Anordnung nach Anspruch 9, dadurch gekennzeichnet, daß die Zeitkonstante der Integrierschaltung (35) so eingestellt ist, daß die negative Steigung etwa gleich der negativen Steigung der Rückflanken der zeittransformierten Empfangsimpulse (E') ist.

11. Anordnung nach Anspruch 9 oder 10, dadurch gekennzeichnet, daß im zweiten Schaltungskanal ein als Dynamikkompressor ausgebildeter Verstärker (25') angeordnet ist, dessen Verstärkungsfaktor bei zunehmender Größe des Eingangssignals verringert wird, jedoch bei abnehmender Größe des Eingangssignals konstant bleibt.

12. Anordnung nach einem der Ansprüche 8 bis 11, dadurch gekennzeichnet, daß an den Ausgang des Schwellenwert-Triggers (26) des zweiten Schaltungskanals (15, 26, 27) eine Hilfs-Zeitmeßanordnung (37, 38, 39) derart angeschlossen ist, daß sie durch die Koinzidenz der Rückflanke jedes zeittransformierten Empfangsimpulses (E'r, E') mit dem Triggerpegel ($U_{TrE}$) in Gang gesetzt und durch die Koinzidenz der Vorderflanke jedes nachfolgenden zeittransformierten Empfangsimpulses (E'r, E') gelöscht wird, und daß das Ausgangssignal des Schwellenwert-Triggers (22) des ersten Schaltungskanals die Zeitmessung in der Hilfs-Zeitmeßanordnung (37, 38, 39) beendet und die Übertragung des erreichten Meßwerts auslöst.

13. Anordnung nach Anspruch 12, dadurch gekennzeichnet, daß die Hilfs-Zeitmeßanordnung einen Vorwärts/Rückwärts-Zähler (37) enthält, der Zählimpulse von einem Zählimpulsgenerator (39) über eine vom Ausgangssignal des Schwellenwert-Triggers (26) des ersten Schaltungskanals gesteuerte Torschaltung (38) empfängt und einen von diesem Ausgangssignal gesteuerten Rückstelleingang (37d) hat, daß ein Steuereingang (37b) des Vorwärts/Rückwärts-Zählers (37) mit dem Ausgang (22c) des Schwellenwert-Triggers (22) des ersten Schaltungskanals derart verbunden ist, daß er durch dessen Ausgangssignal von Vorwärtszählung auf Rückwärtszählung umsteuerbar ist, daß das Ausgangssignal des Schwellenwert-Triggers (22) des ersten Schaltungskanals die für die Impulsabstandsmessung verwendete Zeitmeßanordnung (30, 31, 32, 33) in Gang setzt, und daß der Vorwärts/Rückwärts-Zähler (37) beim Erreichen des Zählerstandes Null bei Rückwärtszählung ein Signal liefert, das die für die Impulsabstandsmessung verwendete Zeitmeßanordnung (30, 31, 32, 33) stillsetzt.

## Claims

1. Method for pulse spacing measurement of periodic pulse pairs (S, E) in particular in pulse radar, by measuring the time interval ($T_M$) between the instants of the coincidence of a pulse edge with a trigger level ($U_{Tr}$) which is set in a predetermined ratio to the peak value ($U_S$, $U_E$) of the pulse, characterized in that the pulse pairs are sampled by the sampling method with the aid of sampling pulses (A) whose recurrence period ($T_A$) is smaller by a predetermined small time difference ($\Delta t$) than the recurrence period ($T_S$) of the pulse pairs, that for each time-transformed pulse (S', E') obtained by the sampling the peak value ($U_{S'}$, $U_{E'}$) is determined and the trigger level ($U_{TrS}$, $U_{TrE}$) having predetermined ratio to the peak value is set, and that the measurement of the time interval ($T'_M$) between the instants of the coincidence is effected by means of the coincidence of the trailing pulse edge of each time-transformed pulse with the associated trigger level.

2. Method according to claim 1, characterized in that the trigger level is set to half the peak value ($U_{S'}/2$, $U_{E'}/2$).

3. Method according to claim 1 or 2, characterized in that the sampling pulses (A) are produced at the instants of the coincidence of the rising edges of a fast sawtooth signal ($SZ_1$), whose period is equal to the recurrence period ($T_S$) of the pulse pairs (S, E) with the falling edge of a slow sawtooth signal ($SZ_2$) varying in the opposite sense (Fig. 9).

4. Method according to claim 1 or 2, characterized in that the recurrence periods of the pulse pairs (S, E) are initiated by synchronising pulses which are produced at the instants of the coincidence of the rising edges of a fast sawtooth signal ($SZ_1$), whose period is equal to the recurrence period of the sampling pulses (A), with the rising edge of a slow sawtooth signal ($SZ_2$ in Fig. 8) varying in the same sense.

5. Arrangement for carrying out the method according to any one of the preceding claims comprising at least one sampling circuit which is controlled by the sampling pulses and furnishes the time-transformed pulses (S', E') at the output, characterized in that the output (14c, 15c) of each sampling circuit (14, 15) is connected to the signal input (22a, 26a) of a threshold trigger (22, 26) which furnishes at the output (22c, 26c) a signal when the trailing edge of its input signal is in coincidence with the trigger level ($U_{TrS}$, $U_{TrE}$) which is applied to a trigger level input (22b, 26b), that the output (14c, 15c) of each sampling circuit (14, 15) is also connected to the signal input (23a, 27a) of a storing peak value detector (23, 27) which furnishes at the output (23c, 27c) a signal ($U_{PS}$, $U_{PE}$) which is resettable at the start of each measuring cycle to an initial value and thereafter corresponds to the maximum value of its input signal reached since the last resetting, that a signal ($U_{TrS}$, $U_{TrE}$) bearing a predetermined ratio to the output signal of the peak value detector is applied to the trigger level input (22b, 26b) of the threshold trigger (22, 26), and that a time measuring means (30, 31, 32, 33) is provided for measuring the interval ($T'_M$) between the output signal of a threshold trigger (26) corresponding to the one time-transformed pulse (E') of each pulse pair (E', S') and the output signal a threshold trigger (22) corresponding to the other time-transformed pulse (S') of each pulse pair (E', S').

6. Arrangement according to claim 5, characterized in that for the two pulses (S, E) of each pulse pair separate circuit channels are provided each having a sampling circuit (14, 15), a threshold trigger (22, 26) and a storing peak value detector (23, 27).

7. Arrangement according to claim 6, characterized in that the output signal of the threshold trigger (26) contained in a circuit channel sets the time measuring means (30, 31, 32, 33) in operation and the output signal of the threshold trigger (22) contained in the other circuit channel stops the time measuring means.

8. Arrangement according to claim 6 or 7 in pulse radar, characterized in that the pulses applied to the first circuit channel (14, 22, 23) are the transmitted pulses (S) and the pulses applied to the second circuit channel (15, 26, 27) are the received pulses (E) of the pulse radar system.

9. Arrangement according to claim 8, characterized in that in the second circuit channel the sampling circuit (15) is followed by an integrating circuit (35) which limits the dropping rate of its output signal to a predetermined negative slope.

10. Arrangement according to claim 9, characterized in that the time constant of the integrating circuit (35) is set so that the negative slope is substantially equal to the negative slope of the trailing edges of the time-transformed received pulses (E').

11. Arrangement according to claim 9 or 10, characterized in that in the second circuit channel an amplifier (25') constructed as dynamic compressor is disposed whose gain becomes smaller with increasing magnitude of the input signal but remains constant with decreasing magnitude of the input signal.

12. Arrangement according to any one of claims 8 to 11, characterized in that to the output of the threshold trigger (26) of the second circuit channel (15, 26, 27) an auxiliary time measuring means (37, 38, 39) is connected in such a manner that it is set in operation by the coincidence of the trailing edge of each time-transformed received pulse (E'r, E') with the trigger level ($U_{TrE}$) and is cleared by the coincidence of the leading edge of each following time-transformed received pulse (E'r, E'), and that the output signal of the threshold trigger (22) of the first circuit channel terminates the time measurement in the auxiliary time measuring means (37, 38, 39) and initiates the transfer of the measured value reached.

13. Arrangement according to claim 12, characterized in that the auxiliary time measuring means contains an up/down counter (37) which receives counting pulses from a counting pulse generator (39) via a gate circuit (38) controlled by the output signal of the threshold trigger (26) of the first circuit channel and has a reset input (37d) controlled by said output signal, that a control input (37b) of the up/down counter (37) is connected to the output (22c) of the threshold trigger (22) of the first circuit channel in such a manner that it is reversible by the output signal thereof from up counting to down couting, that the output signal of the threshold trigger (22) of the first circuit channel sets the time measuring means (30, 31, 32, 33) used for the time spacing measurement in operation, and that the up/down counter (37) on reaching the count zero during downward counting furnishes a signal which stops the time measuring means (30, 31, 32, 33) used for the pulse spacing measurement.

## Revendications

1. Procédé de mesure d'intervalle entre impulsions, dans le cas de paires d'impulsions périodiques (S, E), notamment pour la localisation ou la mesure de distances par réflexion d'impulsions, en mesurant l'intervalle de temps ($T_M$) entre les instants de coincidence d'un flanc d'impulsion et d'un niveau de déclenchement ($U_{Tr}$), ledit niveau étant établi à une valeur qui est dans une proportion constante par rapport à la valeur de crête ($U_S$, $U_E$) des impulsions (S, E) caractérisé en ce qu'on soumet les paires d'impulsions à un échantillonnage au moyen d'impulsions d'échantillonnage (A) dont la période de récurrence ($T_A$) est, d'une petite différence de temps ($\Delta t$) prédéterminée plus petite que la période de récurrence ($T_S$) des paires d'impulsions, en ce qu'on détermine la valeur de crête ($U_{S'}$, $U_{E'}$) de chaque impulsion (S', E') transformée temporelle obtenue par l'échantillonnage et on établit le niveau de déclenchement ($U_{TrS}$, $U_{TrE}$) à une valeur se trouvant dans une proportion prédéterminée par rapport à cette valeur de crête, et en ce qu'on effectue la mesure de l'intervalle de temps ($T'_M$) compris entre les instants de coincidence en se basant sur la coincidence du flanc arrière de chaque impulsion transformée temporelle et du niveau de déclenchement y relatif.

2. Procédé selon la revendication 1, caractérisé en ce que le niveau de déclenchement est établi à la moitié ($U_{S'}/2$, $U_{E'}/2$) de la valeur de crête.

3. Procédé selon les revendications 1 ou 2, caractérisé en ce que les impulsions d'échantillonnage (A) sont produites aux instants où il y a coincidence entre le flanc montant d'une dent de scie d'un signal en dents de scie rapides ($SZ_1$) dont la période est égale à la période de récurrence ($T_S$) des paires d'impulsions (S, E) et le flanc descendant d'une dent de scie d'un signal en dents de scie lentes ($SZ_2$) dont le sens de variation est opposé à celui des dents de scie rapides (figure 9).

4. Procédé selon les revendications 1 ou 2, caractérisé en ce que les périodes de récurrence des paires d'impulsions (S, E) sont déclenchées par des impulsions de synchronisation qui sont produites aux instants où il y a coincidence entre le flanc montant d'une dent de scie d'un signal en dents de scie rapides ($SZ_1$) dont la période est égale à la période de récurrence des impulsions d'échantillonnage (A) et le flanc montant d'une dent de scie d'un signal en dents de scie lentes ($SZ_2$) dont le sens de variation est identique à celui des dents de scie rapides.

5. Dispositif de mise en oeuvre du procédé selon l'une quelconque des revendications précédentes, comportant, commandé par les impulsions d'échantillonnage, au moins un circuit d'échantillonnage fournissant, à sa sortie, les impulsions transformées dans le temps, dites »transformées temporelles« (S', E'), caractérisé en ce que la sortie (14c, 15c) de chaque circuit d'échantillonnage (14, 15) est reliée à l'entrée de signal (22a, 26a) d'un déclencheur à seuil (22, 26) dont la sortie (22c, 26c) fournit un signal lorsque le flanc arrière de son signal d'entrée est en coincidence avec un niveau de gâchette ($U_{TrS}$, $U_{TrE}$) appliqué à une entrée »niveau de gâchette« (22b, 26b), en ce que la sortie (14c, 15c) de chaque circuit d'échantillonnage (14, 15) est en outre reliée à l'entrée de signal (23a, 27a) d'un détecteur-mémorisateur de valeur de crête (23, 27) dont la sortie (23c, 27c) fournit un signal ($U_{PS}$, $U_{PE}$) qui est re-initialisé à une valeur initiale au début de chaque cycle de mesure et qui correspond ensuite à la plus grande des valeurs atteintes par le signal d'entrée de ce détecteur (23, 27) depuis la dernière re-initialisation, en ce qu'un signal ($U_{TrS}$, $U_{TrE}$) se trouvant dans une proportion prédéterminée par rapport au signal de sortie du détecteur de valeur de crête est appliqué à l'entrée »niveau de gâchette« (22b, 26b) du déclencheur à seuil (22, 26), et en ce qu'un dispositif de mesure de temps (30, 31, 32, 33) est prévu pour la mesure de l'intervalle de temps $T'_M$ entre le signal de sortie d'un déclencheur à seuil (26), ce signal de sortie correspondant à la première impulsion transformée temporelle (E') de chaque paire d'impulsions (E', S'), et le signal de sortie d'un déclencheur à seuil (22), ce dernier signal de sortie correspondant à l'autre impulsion transformée temporelle (S') de chaque paire d'impulsions (E', S').

6. Dispositif selon la revendication 5, caractérisé en ce que, pour les deux impulsions (S, E) de chaque paire d'impulsions, il est prévu des canaux séparés comportant chacun un circuit d'échantillonnage (14, 15), un déclencheur à seuil (22, 26) et un détecteur-mémorisateur de valeur de crête (23, 27).

7. Dispositif selon la revendication 6, caractérisé en ce que le signal de sortie du déclencheur à seuil (26) contenu dans un canal met le dispositif de mesure de temps (30, 31, 32, 33) en marche, et le signal de sortie du déclencheur à seuil (22) contenu dans l'autre canal arrête le dispositif de mesure de temps.

8. Dispositif selon la revendication 6 ou 7, utilisé en localisation par réflexion d'impulsions, caractérisé en ce que les impulsions amenées au premier canal (14, 22, 23) sont les impulsions émises (S), et les impulsions amenées au deuxième canal (15, 25, 27) sont les impulsions reçues (E) du système de localisation par réflexion d'impulsions.

9. Dispositif selon la revendication 8, caractérisé en ce que, dans le deuxième canal, en aval du circuit d'échantillonnage (15), un circuit intégrateur (35) est disposé, qui limite la décroissance de son signal de sortie à une pente négative prédéterminée.

10. Dispositif selon la revendication 9, caractérisé en ce que la constante de temps du circuit intégrateur (35) est établie de façon que la pente négative soit sensiblement égale à la pente négative des flancs arrières des impulsions transformées temporelles (E') reçues.

11. Dispositif selon les revendications 9 ou 10, caractérisé en ce que dans le deuxième canal, un amplificateur (25') constitué en compresseur de dynamique est disposé, dont le facteur d'amplification diminue lorsque la grandeur du signal d'entrée croît, et reste constant lorsque la grandeur du signal d'entrée décroît.

12. Dispositif selon l'une quelconque des revendications 8 à 11, caractérisé en ce qu'à la sortie du déclencheur à seuil (26) du deuxième canal (15, 26, 27) est raccordé un dispositif auxiliaire de mesure de temps (37, 38, 39) de façon qu'il soit mis en marche par la coincidence du flanc arrière de chaque impulsion transformée temporelle reçue (E'r, E') avec le niveau de gâchette ($U_{TrE}$), et soit re-initialisé par la coincidence du flanc avant de chaque impulsion transformée temporelle reçue suivante (E'r, E'), et en ce que le signal de sortie du déclencheur à seuil (22) du premier canal met fin à la mesure du temps dans le dispositif auxiliaire de mesure de temps (37, 38, 39), et déclenche la transmission de la valeur de mesure atteinte.

13. Dispositif selon la revendication 12, caractérisé en ce que le dispositif auxiliaire de mesure de temps comporte un compteur-décompteur (37) qui reçoit par l'intermédiaire d'un circuit de porte (38) commandé par le signal de sortie du déclencheur à seuil (26) du premier canal des impulsions de comptage provenant d'un générateur d'impulsions (39), et qui possède une entrée de re-initialisation (37d) commandée par le signal de sortie du déclencheur à seuil, en ce qu'une entrée de commande (37b) du compteur-décompteur (37) est reliée à la sortie (22c) du déclencheur à seuil (22) du premier canal de façon que le signal de sortie de ce déclencheur (22) le fasse passer du mode »comptage« au mode »décomptage«, en ce que le signal de sortie du déclencheur à seuil (22) du premier canal met en marche le dispositif de mesure de temps (30, 31, 32, 33) utilisé pour la mesure d'intervalle entre impulsions, et en ce que le compteur-décompteur (37) fournit, lorsque son niveau de comptage arrive au zéro lors du décomptage, un signal qui arrête le dispositif de mesure de temps (30, 31, 32, 33) utilisé pour la mesure d'intervalle entre impulsions.

0 025 086

Fig.1

Fig.2

Fig.3

Fig.4

Fig. 5

0025 086

Fig. 6

Fig. 7

Fig. 8

0 025 086

Fig. 9

SEA

ZM

**Fig.10**

12 Taktgeber

13 Sender-steuerstufe

10 Infrarot-impulssender

11 Infrarot-empfänger

16 Abtastimpuls-generator

18 Frequenz-teiler

19 langsamer Sägezahn-generator

17 schneller Sägezahn-generator

20 Komp.

$SZ_2$

$SZ_1$

R

14 Abtast-schaltung

15 Abtast-schaltung

21 Verstärker

25 Verstärker

22 Schwellenwert-Trigger

26 Schwellenwert-Trigger

23 speichernder Spitzenwert-detektor

27 speichernder Spitzenwert-detektor

29 bistabile Kippschaltung

31 Zählimpuls-generator

30 Torschaltung

32 Zähler

33 Anzeige

S

E

S'

E'

A

K1

K2

14a 14b 14c

15a 15b 15c

22a 22b 22c

26a 26b 26c

23a 23b 23c

27a 27b 27c

$U_{TrS}$

$U_{TrE}$

$U_{PS}$

$U_{PE}$

24

28

R

29a 29b 29c

G

35

Fig.11

Fig. 12

SEA

0 025 086

39

**Fig.13**

**Fig.14**

Fig.15

Fig.16

Fig. 17

0 025 086

Fig.18

47